# EUROPEAN PATENT SPECIFICATION

(11) **EP 3 229 075 B1**
(45) Date of publication and mention of the grant of the patent: **06.01.2021**
(21) Application number: 15865292.5
(22) Date of filing: 26.11.2015
(51) Int. Cl.: G03F 7/004, G03F 7/039

(54) **PHOTORESIST COMPOSITION, METHOD FOR MANUFACTURING SAME, AND METHOD FOR FORMING RESIST PATTERN**
FOTOLACKZUSAMMENSETZUNG, VERFAHREN ZUR HERSTELLUNG DAVON UND VERFAHREN ZUR FORMUNG EINER LACKSTRUKTUR
COMPOSITION DE RÉSINE PHOTOSENSIBLE, PROCÉDÉ DE FABRICATION DE CETTE DERNIÈRE ET PROCÉDÉ DE FORMATION D'UN MOTIF DE RÉSERVE

(30) Priority: 02.12.2014 JP 2014244536
(43) Date of publication of application: 11.10.2017
(73) Proprietor: JSR Corporation, Minato-ku Tokyo 105-8640 (JP)
(72) Inventor: NAKAGAWA Hisashi, Tokyo 105-8640 (JP); SHIRATANI Motohiro, Tokyo 105-8640 (JP); NARUOKA Takehiko, Tokyo 105-8640 (JP); NAGAI Tomoki, Tokyo 105-8640 (JP)
(74) Representative: TBK
(86) International application number: PCT/JP2015/083298
(87) International publication number: WO 2016/088655

(56) References cited:
- WO-A1-2009/110166
- WO-A1-2014/136922
- JP-A- 2006 098 568
- JP-A- 2006 108 072
- JP-A- 2006 284 947
- JP-A- 2007 016 214
- JP-A- 2010 002 538
- JP-A- 2012 185 485
- JP-A- 2013 025 211
- JP-A- 2013 083 844
- JP-A- 2014 071 306
- JP-A- 2014 085 612
- JP-A- 2014 170 189
- JP-A- 2014 199 919
- JP-A- 2015 157 807
- US-A1- 2013 108 956
- TADATOMI NISHIKUBO ET AL: "Novel Noria (Water Wheel-Like Cyclic Oligomer) Derivative as a Chemically Amplified Extreme Ultraviolet (EUV)-Resist Material", JOURNAL OF PHOTOPOLYMER SCIENCE AND TECHNOLOGY, vol. 22, no. 1, 1 January 2009 (2009-01-01), pages 73-76, XP055495995, JP ISSN: 0914-9244, DOI: 10.2494/photopolymer.22.73
- MARKOS TRIKERIOTIS ET AL.: 'Nanoparticle Photoresists from Hf02 and Zr02 for EUV Patterning' JOURNAL OF PHOTOPOLYMER SCIENCE AND TECHNOLOGY vol. 25, no. 5, 01 January 2012, pages 583 - 586, XP055222227 DOI: 10.2494/PHOTOPOLYMER.25.583
- Thierry Cassagneau ET AL: "Optical and Electrical Characterizations of Ultrathin Films Self-Assembled from 11-Aminoundecanoic Acid Capped TiO 2 Nanoparticles and Polyallylamine Hydrochloride +", Langmuir, vol. 16, no. 1, 1 January 2000 (2000-01-01), pages 241-246, XP055015910, ISSN: 0743-7463, DOI: 10.1021/la990776h

## Description

### [TECHNICAL FIELD]

The present invention relates to a photoresist composition, a production method of the photoresist composition, and a resist pattern-forming method.

### [BACKGROUND ART]

Conventionally, production processes of semiconductor devices such as IC and LSI have involved microfabrication by way of lithography in which a photoresist composition is used. In recent years, enhanced integration of integrated circuits has been accompanied by a demand for ultra-fine pattern formation in the sub-micron region and the quarter-micron region. Consequently, there has been a tendency of shortening of an exposure wavelength e.g., from a g-line to an i-line, to a KrF excimer laser beam, and further to an ArF excimer laser beam. Recently, lithography techniques are being developed in which an extreme ultraviolet ray (EUV), an electron beam, etc. are used in addition to the excimer laser beam (refer to Japanese Unexamined Patent Application, Publication Nos. 2006-171440, 2011-16746, and 2010-204634).

The aforementioned lithography techniques in which EUV or an electron beam is utilized are expected to be pattern formation techniques of the next generation that enable pattern formation in an ultra-fine region of no greater than 32 nm. However, exposure in which EUV is utilized has a disadvantage of low throughput due to a low power of the exposure light source. It has therefore been of great importance to solve this disadvantage, and studies have been conducted in relation to an apparatus for increasing power output, whereas it is still absolutely necessary to achieve an increase in sensitivity of photoresist compositions. During the lithography process in which EUV is utilized, secondary electrons are generated from a polymer etc. in a photoresist composition upon irradiation with EUV, and then absorbed by a photoacid generating agent, whereby an acid is generated through decomposition of the photoacid generating agent. Therefore, it is demanded to further promote decomposition of the photoacid generating agent through improving EUV light absorption efficiency of the photoresist composition.

### [PRIOR ART DOCUMENTS]

### [PATENT DOCUMENTS]

Patent Document 1: Japanese Unexamined Patent Application, Publication No. 2006-171440
Patent Document 2: Japanese Unexamined Patent Application, Publication No. 2011-16746
Patent Document 3: Japanese Unexamined Patent Application, Publication No. 2010-204634

US 2013 / 0 108 956 A1 relates to a positive photosensitive composition suitable for image-wise exposure and development as a positive photoresist comprising a positive photoresist composition and an inorganic particle material having an average particle size equal or greater than 10 nanometers, wherein the thickness of the photoresist coating film is less than 5 microns.

WO 2014 / 136 922 A1 relates to a photosensitive resin composition containing inorganic particles, a dispersing agent, a solvent, a polymer containing a constituent unit having a group such that an acid group is protected by an acid labile group, and a photoacid generator, where the inorganic particles are metal oxide particles containing titanium as an element, and having a volume average particle size (D50) of 0.1-20 nm.

JP 2014 - 085 612 A relates to a photosensitive resin composition which comprises: two or more inorganic particles having different refractive indices and/or different particle diameters, which preferably is a metal oxide particle and more preferably is a titanium dioxide particle and a zirconium oxide particle; a dispersant; a solvent; a polymer containing a constituent unit having a group in which an acid group is protected by an acid-decomposable group; and a photoacid generator.

Markos Trikeriotis et al (Journal of Photopolymer Science and Technology, 2012, Volume 25, Issue 5, Pages 583-586) describes the use of inorganic nanoparticle photoresists for 193 nm and e-beam lithography, wherein these inorganic photoresists are made of oxide nanoparticles and have shown etch resistance that is 25 times higher than polymer resists.

Thierry Cassagneau et al (Langmuir 2000, 16, 1, 241-246) describes that 11-Aminoundecanoic acid capped titanium dioxide (capped-TiO₂) nanoparticles and polyallylamine hydrochloride have been layer-by-layer self-assembled onto precoated (by poly(diallyldimethylammonium chloride) substrates.

### [SUMMARY OF THE INVENTION]

### [PROBLEMS TO BE SOLVED BY THE INVENTION]

In view of such circumstances, it is an object of the present invention to provide a photoresist composition of which absorption efficiency of EUV or an electron beam is improved, thus in turn promoting decomposition of the photoacid generating agent. It is also an object of the present invention to provide a photoresist composition that, even if a particulate component is contained therein, enables a favorable pattern to be formed without deteriorating storage stability and a nanoedge roughness property.

### [MEANS FOR SOLVING THE PROBLEMS]

According to an aspect of the invention made for solving the aforementioned problems, a photoresist composition comprises: a radiation-sensitive acid generator that is capable of generating an acid upon irradiation with a radioactive ray (hereinafter, may be also referred to as "(B) acid generator" or "acid generator (B)"), an action of the acid allowing a solubility in a developer solution to be altered; first particles comprising a metal element and having a hydrodynamic radius as determined by a dynamic light scattering analysis being no greater than 20 nm (hereinafter, may be also referred to as "(C) particles" or "particles (C)"); and a first solvent (hereinafter, may be also referred to as "(G) solvent" or "solvent (G)") wherein the metal element is zirconium, hafnium, tantalum, tungsten, iron, zinc, tin, or bismuth.

The photoresist composition according to the aspect of the invention comprises the particles (C) comprising the metal element and having a hydrodynamic radius as determined by the dynamic light scattering analysis being no greater than 20 nm. Due to comprising such particles (C), an absorption efficiency of EUV or an electron beam, in particular, is improved to consequently promote decomposition of the photoacid generating agent, whereby an increase in sensitivity is enabled without deteriorating the nanoedge roughness property.

The photoresist composition according to the aspect of the invention comprises a first compound comprising an acid-labile group (hereinafter, may be also referred to as "(A) compound" or "compound (A)").

In the photoresist composition according to the aspect of the invention, the radiation-sensitive acid generator may be the compound (A) comprising a group that is capable of generating an acid upon irradiation with a radioactive ray. Due to the compound (A) further comprising the group that is capable of generating an acid upon exposure, the acid is distributed uniformly in a resist film, thereby enabling an acid diffusion length to be appropriately controlled, whereby size uniformity and a resolution of the pattern are expected to be improved.

The photoresist composition according to the aspect of the invention may comprise a radiation-sensitive acid generating agent (hereinafter, may be also referred to as "(B) acid generating agent" or "acid generating agent (B)") as the acid generator (B).

In the photoresist composition according to the aspect of the invention, the compound (A) is a first polymer (hereinafter, may be also referred to as "(A) polymer" or "polymer (A)") comprising a first structural unit (hereinafter, may be also referred to as "structural unit (I)") comprising an acid-labile group, or a combination thereof. In a referenced embodiment useful to understand that invention, the compound (A) is a single molecule having an acid-labile group (hereinafter, may be also referred to as "(A) single molecule" or "single molecule (A)").

In the photoresist composition according to the aspect of the invention, a content of the particles (C) may be no greater than 20 parts by mass with respect to 100 parts by mass of the compound (A).

In the photoresist composition according to the aspect of the invention, the polymer (A) may be a polymer comprising a second structural unit (hereinafter, may be also referred to as "structural unit (II)") comprising an aromatic ring having 6 to 20 carbon atoms in the ring thereof.

In the photoresist composition according to the aspect of the invention, at least one hydroxy group may bond to the aromatic ring in the structural unit (II).

As the particles (C),
a complex or a hydrolytic condensation product thereof is used, the complex being obtained by mixing a metal-containing compound which is a first metal compound (hereinafter, may be also referred to as "(I) metal compound" or "metal compound (I)") comprising a hydrolyzable group, a hydrolysis product of the metal compound (I), a hydrolytic condensation product of the metal compound (I), or a combination thereof, with at least one type of organic compound represented by formula (L-1):

R¹(̵X)ₙ (L-1)

wherein in the formula (L-1),
R¹ represents an organic group having a valency of n;
X represents -OH, -COOH, -NCO, -NHR^{a}, -COOR^{A}, or -CO-C(R^{L})₂-CO-R^{A},
   R^{a} representing a hydrogen atom or a monovalent organic group,
   R^{A} representing a monovalent organic group, and
   R^{L} each independently representing a hydrogen atom or a monovalent organic group; and
n is an integer of 1 to 4,
in a case where n is no less than 2, a plurality of Xs may be identical or different.

In the photoresist composition according to the aspect of the invention, as the metal-containing compound to be mixed with the organic compound, a metal alkoxide having been neither hydrolyzed nor hydrolytically condensed may be used.

In the photoresist composition according to the aspect of the invention, in the formula (L-1), X may represent -OH, and n may be 2 to 4.

In the photoresist composition according to the aspect of the invention, in the formula (L-1), X may represent -COOH, and n may be 1.

In the photoresist composition according to the aspect of the invention, the solvent (G) may comprise an aprotic solvent in an amount of no less than 80% by mass.

In the photoresist composition according to the aspect of the invention, the solvent (G) may comprise a protic solvent in an amount of no greater than 20% by mass.

According to another aspect of the invention made for solving the aforementioned problems, a production method of the photoresist composition comprises mixing a liquid obtained by dispersing the particles (C) in a second solvent (hereinafter, may be also referred to as "(S) solvent" or "solvent (S)"), with other components.

The production method according to the another aspect of the invention may comprise dispersing in the solvent (S) the particles (C) in a state of a solid.

In the production method according to the another aspect of the invention, the solvent (S) may be an aprotic solvent.

According to still another aspect of the invention made for solving the aforementioned problems, a resist pattern-forming method comprises: providing a resist film; exposing the resist film by irradiating with an extreme ultraviolet ray or an electron beam; and developing with a developer solution the resist film exposed, wherein the resist film is provided from the photoresist composition.

In the resist pattern-forming method according to the still another aspect of the invention, an aqueous alkaline solution may be used as the developer solution.

In the resist pattern-forming method according to the still another aspect of the invention, an organic solvent may be used as the developer solution.

### [EFFECTS OF THE INVENTION]

The aspects of the present invention enable absorption efficiency of EUV or an electron beam, in particular, to be improved to consequently promote decomposition of the photoacid generating agent or the like, whereby a highly sensitive photoresist composition may be provided. In addition, the photoresist composition according to the aspect of the present invention, even though a particulate component is contained therein, enables a favorable pattern to be formed with superior storage stability over time and without deteriorating the nanoedge roughness property. Therefore, the photoresist composition may be suitably used for forming resist patterns, more specifically for forming fine resist patterns in lithography processes for various types of electronic devices such as semiconductor devices and liquid crystal devices.

### [BRIEF DESCRIPTION OF THE DRAWINGS]

FIG. 1 shows a schematic plan view illustrating a line-pattern when seen from above; and
FIG. 2 shows a schematic cross sectional view illustrating a line-pattern configuration.

### [DESCRIPTION OF EMBODIMENTS]

### Photoresist Composition

The photoresist composition comprises: the radiation-sensitive acid generator (B) that is capable of generating an acid upon irradiation with a radioactive ray, an action of the acid allowing a solubility in a developer solution to be altered; the particles (C) comprising a metal element and having a hydrodynamic radius as determined by the dynamic light scattering analysis being no greater than 20 nm; and the solvent (G). The radioactive ray is exemplified by: electromagnetic waves such as visible light rays, ultraviolet rays, far ultraviolet rays (e.g., a KrF excimer laser beam (wavelength: 248 nm) and an ArF excimer laser beam (wavelength: 193 nm)), EUV, X-rays and γ-rays; charged particle rays such as electron beams and α-rays; and the like. Of these, far ultraviolet rays, EUV, X-rays and electron beams are preferred; EUV, X-rays and electron beams are more preferred; and EUV and electron beams are still more preferred.

As the acid generator (B), either a component that is capable of generating an acid upon irradiation with a radioactive ray, or a component that is capable of generating an acid by an action of a secondary electron generated by ionization of a component such as a polymer, contained in the photoresist composition, as in the case of irradiation with EUV light, may be used.

The photoresist composition contains the compound (A) having an acid-labile group, as a component that allows a solubility in a developer solution to be altered by an action of the acid. The acid-labile group as referred to means a group that will be dissociated by the action of the acid generated from the component that is capable of generating the acid upon irradiation with the radioactive ray, i.e., a group in which an acidic group such as a carboxy group, a hydroxyl group and a sulfo group is protected by a leaving group, and serves to alter a solubility of a resist film in a developer solution.

The acid generator (B) may be the compound (A) into which the group that is capable of generating an acid upon irradiation with a radioactive ray has been introduced, the acid generating agent (B) that is capable of generating an acid upon irradiation with a radioactive ray, or a combination thereof.

It is to be noted that the photoresist composition preferably further contains an acid diffusion controller in addition to the acid generator (B), the particles (C) and the solvent (G), within a range not leading to impairment of the effects of the present invention. The photoresist composition may further contain other optional components, within a range not leading to impairment of the effects of the present invention. Hereinafter, each component will be described in detail.

### (A) Compound

The compound (A) has an acid-labile group. The compound (A) is a polymer (A) comprising a structural unit (I) having an acid-labile group.

### (A) Single Molecule - Reference Embodiment useful to understand the invention

The single molecule (A) is exemplified by a compound represented by the following formula (1) (hereinafter, may be also referred to as "compound (a)"). The compound (a) is an acid-labile group-containing (modified) compound having a structure in which at least one of hydroxy groups is protected by an acid-labile group having a substituted or unsubstituted ring structure. Therefore, the compound (a) has a solubility in a developer solution altered due to a polarity change caused by dissociation of the acid-labile group thereof by an acid.

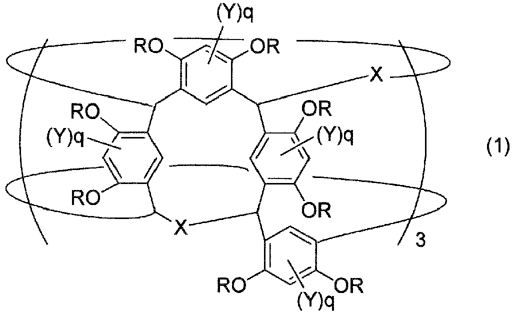

In the above general formula (1): Rs each independently represent a hydrogen atom, the acid-labile group having a substituted or unsubstituted ring structure, or the group that is capable of generating an acid upon irradiation with a radioactive ray, wherein at least one R represents the acid-labile group having a substituted or unsubstituted ring structure; Xs each independently represent a substituted or unsubstituted alkylene group having 1 to 8 carbon atoms; Ys each independently represent a substituted or unsubstituted alkyl group having 1 to 10 carbon atoms, a substituted or unsubstituted alkenyl group having 2 to 10 carbon atoms, a substituted or unsubstituted alkynyl group having 2 to 10 carbon atoms, a substituted or unsubstituted aralkyl group having 7 to 10 carbon atoms, a substituted or unsubstituted alkoxy group having 1 to 10 carbon atoms, or a substituted or unsubstituted phenoxy group; and q is each independently 0 or 1.

It is to be noted that the above general formula (1) may also be represented as the following general formula (1-1).

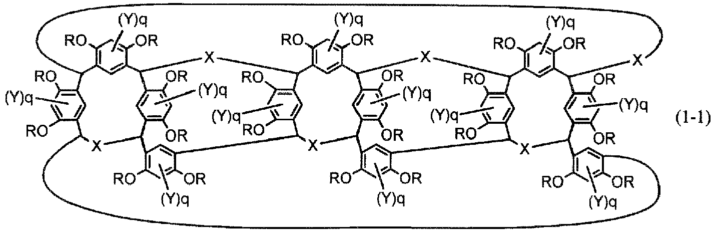

In the above general formula (1-1), Rs each independently represent a hydrogen atom or the acid-labile group having a substituted or unsubstituted ring structure, wherein at least one R represents the acid-labile group having a substituted or unsubstituted ring structure; Xs each independently represent a substituted or unsubstituted alkylene group having 1 to 8 carbon atoms; Ys each independently represent a substituted or unsubstituted alkyl group having 1 to 10 carbon atoms, a substituted or unsubstituted alkenyl group having 2 to 10 carbon atoms, a substituted or unsubstituted alkynyl group having 2 to 10 carbon atoms, a substituted or unsubstituted aralkyl group having 7 to 10 carbon atoms, a substituted or unsubstituted alkoxy group having 1 to 10 carbon atoms, or a substituted or unsubstituted phenoxy group, and q is each independently 0 or 1.

Examples of a substituent for the substituted alkyl group having 1 to 10 carbon atoms as Y in the compound represented by the general formula (1) include a methyl group, an ethyl group, a propyl group, a butyl group, and the like. Of these, a propyl group and a butyl group are preferred from the perspective that obtaining a high yield of the compound represented by the formula (1) is enabled.

Of the compounds that may be represented by the general formula (1), a compound represented by the following general formula (2) is preferred. In other words, in the general formula (1), it is preferred that X represents a propylene group, and q is 0. Of the compounds that may be represented by the general formula (1), the compound represented by the following general formula (2) can be produced in a more favorable yield.

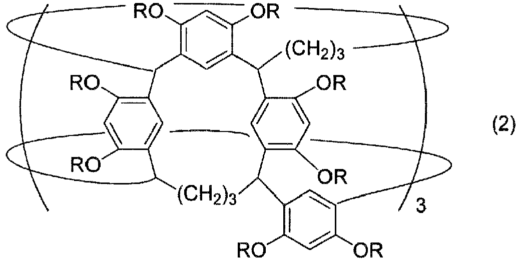

In the above general formula (2), Rs each independently represent a hydrogen atom or the acid-labile group having a substituted or unsubstituted ring structure, wherein at least one R represents the acid-labile group having a substituted or unsubstituted ring structure.

### Acid-Labile Group

In the above general formula (1), Rs each independently represent a hydrogen atom or the acid-labile group having a substituted or unsubstituted ring structure, wherein at least one R represents the acid-labile group having a substituted or unsubstituted ring structure.

Among all Rs in the compound represented by the above general formula (1), a lower limit of a proportion of the acid-labile group is preferably 10 mol%, and more preferably 20 mol%. The upper limit of the proportion of the acid-labile group is preferably 90 mol%, and more preferably 80 mol%. When the proportion of the acid-labile group is less than 10 mol%, a resolution tends to be inferior. On the other hand, when the proportion of the acid-labile group is greater than 90 mol%, adhesiveness of a resist pattern to a substrate tends to be inferior. Here, the proportion of the acid-labile group in the compound represented by the general formula (1) is a value calculated based on a result of ¹H-NMR analysis.

The acid-labile group is not particularly limited in terms of its structure, as long as the group has a substituted or unsubstituted ring structure and is dissociated by an action of an acid. As the acid-labile group, a group represented by the following general formula (2-1) and a group represented by the following general formula (2-2) are preferred. It is to be noted that, since Rs in the above general formula (1) are "each independent", in a case where a plurality of acid-labile groups are present in the above general formula (1), all of Rs may represent the group represented by the following general formula (2-1) or the group represented by the following general formula (2-2); or some of Rs may represent the group represented by the following general formula (2-1) while some of Rs may represent the group represented by the following general formula (2-2).

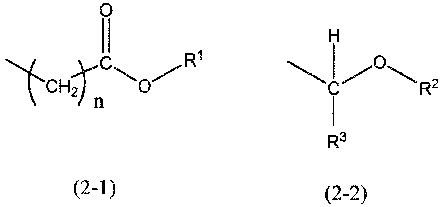

In the above general formula (2-1), R¹ represents a cyclic alkyl group having 6 to 20 carbon atoms unsubstituted or substituted with a substituent that may contain a hetero atom, and n is an integer of 1 to 3. Meanwhile, in the above general formula (2-2), R² represents a cyclic alkyl group having 6 to 20 carbon atoms unsubstituted or substituted with a substituent that may contain a hetero atom, and R³ represents a hydrogen atom or an alkyl group having 1 to 5 carbon atoms.

Examples of the group represented by the above general formula (2-1) include groups represented by the following general formulae (3-1) to (3-7), and the like. It is to be noted that in the following general formulae (3-1) to (3-7), R⁴ represents an alkyl group having 1 to 5 carbon atoms, and n is an integer of 1 to 3.

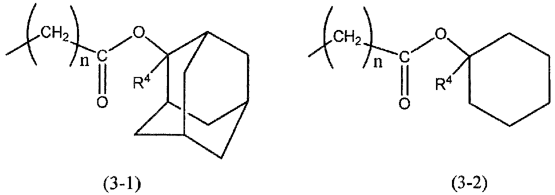

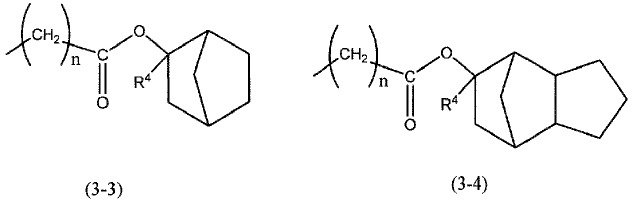

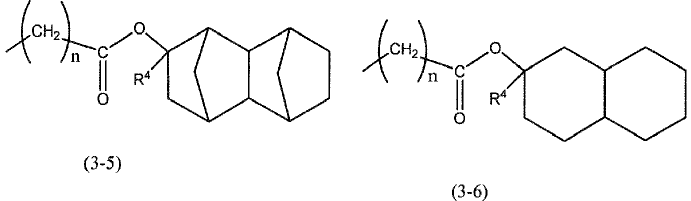

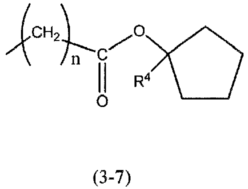

Specific examples of the alkyl group having 1 to 5 carbon atoms represented by R⁴ in the above general formulae (3-1) to (3-7) include linear or branched lower alkyl groups such as a methyl group, an ethyl group, a propyl group, an isopropyl group, an n-butyl group, an isobutyl group, a tert-butyl group, a pentyl group, an isopentyl group and a neopentyl group. Of these, a methyl group and an ethyl group are preferred, and a methyl group is more preferred.

As R¹ in the above general formula (2-1), specifically, a 2-methyl-2-adamantyl group, a 2-ethyl-2-adamantyl group, a 1-ethyl-1-cyclopentyl group, and a 1-methyl-1-cyclopentyl group are preferred. It is to be noted that, in a case where the group represented by the general formula (2-1) is present in a plurality of number, R¹s in the general formula (2-1) may be all the same or different from one another.

As the group represented by the above general formula (2-1), specifically, a 2-methyl-2-adamantyloxycarbonylmethyl group, a 2-ethyl-2-adamantyloxycarbonylmethyl group, a 1-ethylcyclopentyloxycarbonylmethyl group, and a 1-methylcyclopentyloxycarbonylmethyl group are preferred. It is to be noted that, in a case where the group represented by the general formula (2-1) is present in a plurality of number, the groups each represented by the general formula (2-1) may be all the same or different from one another.

Examples of the group represented by the above general formula (2-2) include groups represented by the following general formulae (4-1) to (4-14), and the like. It is to be noted that in the following general formulae (4-1) to (4-14), R³ represents a hydrogen atom or an alkyl group having 1 to 5 carbon atoms; in the following general formulae (4-1) to (4-10), R¹² represents a hydrogen atom or an alkyl group having 1 to 5 carbon atoms; and in the following general formulae (4-1) to (4-10), m is an integer of 0 to 2 and preferably 0 or 1.

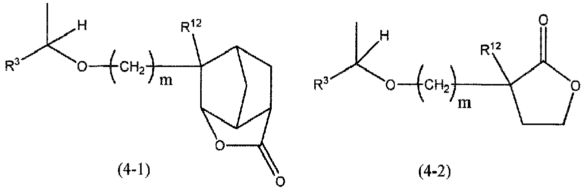

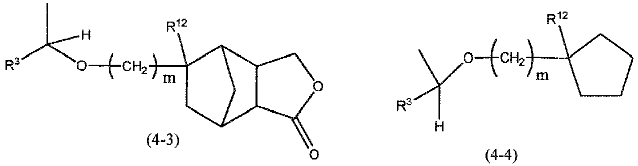

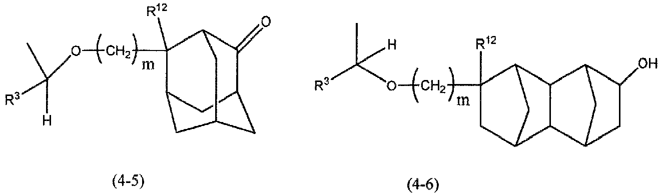

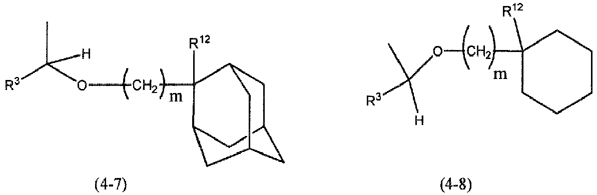

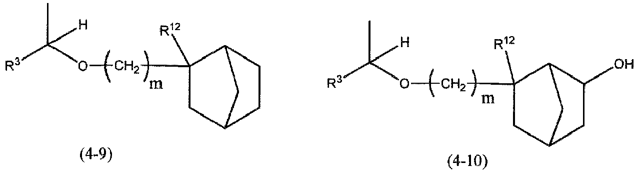

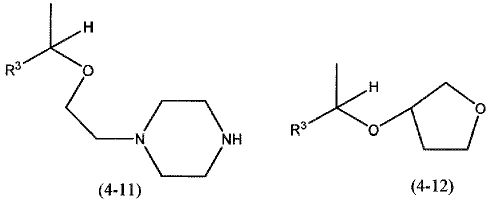

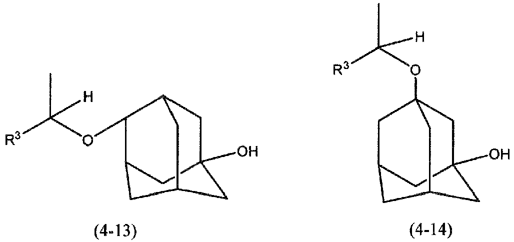

### Group that is capable of Generating Acid upon Irradiation with Radioactive Ray

Examples of the group that is capable of generating an acid upon irradiation with a radioactive ray include a group represented by the following formula (5) and the like.

-A⁻ X⁺ (5)

In the above formula (5): A⁻ represents -N⁻-SO₂-R^{D}, -COO⁻, -O⁻ or -SO₃⁻, wherein R^{D} represents a linear or branched monovalent hydrocarbon group having 1 to 10 carbon atoms, or a cyclic monovalent hydrocarbon group having 3 to 20 carbon atoms, wherein a part or all of hydrogen atoms in these hydrocarbon groups may be substituted with a fluorine atom, and X⁺ represents a monovalent onium cation.

Due to the compound (a) being used as the compound (A), an improvement of etching resistance of a resist film is expected.

### (A) Polymer

The polymer having an acid-labile group comprises the structural unit (I) having an acid-labile group. Such a polymer (A) may comprise, in addition to the structural unit (I):
the structural unit (II) having an aromatic ring having 6 to 20 carbon atoms in the ring thereof;
a structural unit (X) such as
   a structural unit (X1) having a hydrocarbon group substituted with an alcoholic hydroxyl group, a carboxy group, a cyano group and/or a sulfo group, or substituted with a group that is capable of generating an alcoholic hydroxyl group, a carboxy group and/or a sulfo group by an action of an acid or upon irradiation with a radioactive ray, or a combination thereof, a structural unit (X2) having a lactone structure, a cyclic carbonate structure, a sultone structure or a combination thereof, or
   a combination thereof;
   and the like.

Hereinafter, each structural unit will be described in detail. It is to be noted that the polymer (A) may comprise either one, or two or more types of the structural units.

### Structural Unit (I)

The structural unit (I) comprised in the polymer (A) is not particularly limited as long as the structural unit comprises an acid-labile group, and is preferably a structural unit (P-I) represented by the following formula (p-1), a structural unit (P-II) represented by the following formula (p-2), a structural unit (P-III) derived from an acetalized hydroxystyrene, or a combination thereof. The polymer (A) may comprise other structural unit having other acid-labile group, in addition to the structural units (P-I) and (P-III). Due to the polymer (A) comprising such a structural unit, the photoresist composition is enabled to have further favorable sensitivity.

### Structural Unit (P-I)

The structural unit (P-I) is represented by the following formula (p-1).

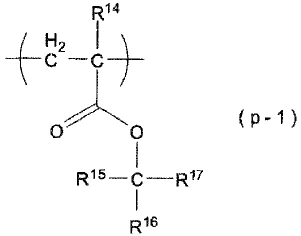

In the above formula (p-1): R¹⁴ represents a hydrogen atom, a fluorine atom, a methyl group, a trifluoromethyl group, or a hydroxymethyl group; R¹⁵ to R¹⁷ each independently represent a linear or branched alkyl group having 1 to 4 carbon atoms, an aryl group having 6 to 22 carbon atoms, or a monovalent alicyclic hydrocarbon group having 4 to 20 carbon atoms or a group derived therefrom, wherein any two of R¹⁵ to R¹⁷ may taken together represent a divalent alicyclic hydrocarbon group or a group derived therefrom together with the carbon atom to the any two of R¹⁵ to R¹⁷ bind,.

Examples of the linear or branched alkyl group having 1 to 4 carbon atoms that may be represented by any one of R¹⁵ to R¹⁷ include a methyl group, an ethyl group, an n-butyl group, an i-butyl group, and the like.

Examples of the aryl group having 6 to 22 carbon atoms that may be represented by any one of R¹⁵ to R¹⁷ include a phenyl group, a naphthyl group, and the like.

Examples of the monovalent alicyclic hydrocarbon group having 4 to 20 carbon atoms that may be represented by any one of R¹⁵ to R¹⁷ include a cyclobutyl group, a cyclopentyl group, a cyclohexyl group, a cyclooctyl group, a norbornyl group, an adamantyl group, and the like. In addition, the group derived therefrom is exemplified by a group in which a part or all of hydrogen atoms comprised in the alicyclic hydrocarbon group is substituted with a substituent.

The divalent alicyclic hydrocarbon group that may be taken together represented by any two of R¹⁵ to R¹⁷ together with the carbon atom to which the any two of R¹⁵ to R¹⁷ bind is exemplified by a cyclobutanediyl group, a cyclopentanediyl group, a cyclohexanediyl group, and the like. In addition, the group derived therefrom is exemplified by a group in which a part or all of hydrogen atoms comprised in the alicyclic hydrocarbon group is substituted with a substituent.

Examples of the structural unit (P-I) include structural units represented by the following formulae (p-1-1) to (p-1-7).

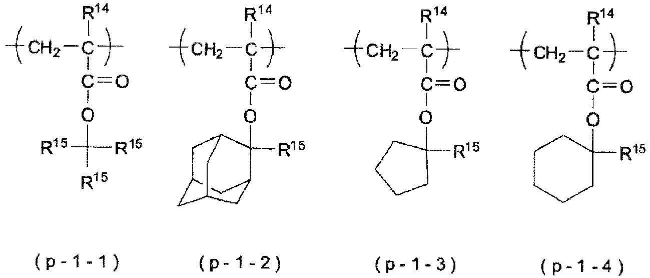

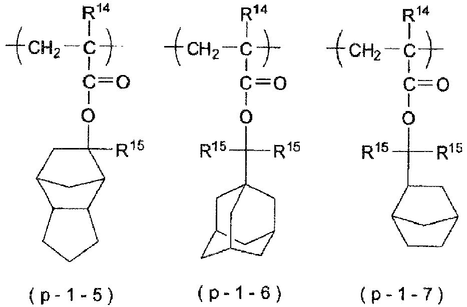

In the above formulae (p-1-1) to (p-1-7), R¹⁴ is as defined for the above formula (p-1); and R¹⁵ represents a linear or branched alkyl group having 1 to 4 carbon atoms, or an aryl group having 6 to 22 carbon atoms.

In light of the copolymerizability of a monomer that gives the structural unit (P-I), R¹⁴ represents preferably a hydrogen atom or a methyl group, and more preferably a methyl group. In light of dissociability of the acid-labile group, R¹⁵ represents preferably a linear or branched alkyl group having 1 to 4 carbon atoms, more preferably a methyl group, an ethyl group and an i-propyl group, and still more preferably a methyl group and an ethyl group.

### Structural Unit (P-II)

The structural unit (P-II) is represented by the following formula (p-2).

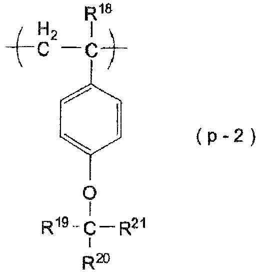

In the above formula (p-2), R¹⁸ represents a hydrogen atom, a methyl group, a trifluoromethyl group, or a hydroxymethyl group; R¹⁹ to R²¹ each independently represent a linear or branched alkyl group having 1 to 4 carbon atoms, an aryl group having 6 to 22 carbon atoms, a monovalent alicyclic hydrocarbon group having 4 to 20 carbon atoms, or a group derived therefrom, wherein any two of R¹⁹ to R²¹ may taken together represent a divalent alicyclic hydrocarbon group or a group derived therefrom together with the carbon atom to which the any two of R¹⁹ to R²¹ bind.

The linear or branched alkyl group having 1 to 4 carbon atoms, the monovalent alicyclic hydrocarbon group having 4 to 20 carbon atoms or a group derived therefrom represented by any one of R¹⁹ to R²¹, and the divalent alicyclic hydrocarbon group that may be taken together represented by any two of R¹⁹ to R²¹ together with the carbon atom to which the any two of R¹⁹ to R²¹ bind or a group derived therefrom are as defined for similar groups which may be represented by any one of R¹⁵ to R¹⁷ in the above formula (p-1), respectively.

### Structural Unit (P-III)

The structural unit (P-III) is derived from an acetalized hydroxystyrene. The acetalized hydroxystyrene has a structure in which an acetal structure is formed from a carbonyl group, a hydroxy group, and a phenolic hydroxyl group of the hydroxystyrene. The structural unit (P-III) is exemplified by structural units represented by the following formulae (p-3-1) to (p-3-4), and the like.

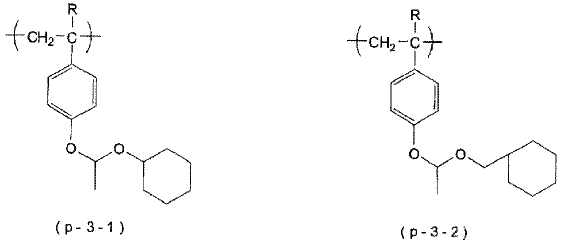

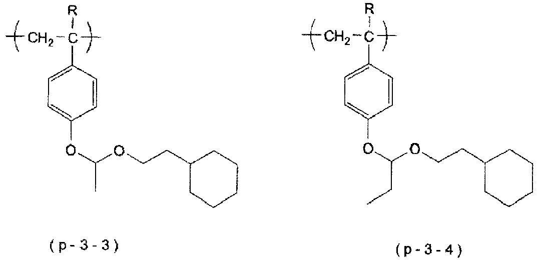

In the above formulae (p-3-1) to (p-3-4), R represents a hydrogen atom, a methyl group, a trifluoromethyl group or a hydroxymethyl group.

### Structural Unit (II)

The structural unit (II) comprises an aromatic ring having 6 to 20 carbon atoms in the ring thereof. The structural unit (II) may be exemplified by: structural units represented by the following formulae (C-1-1) to (C-1-4); structural units represented by the following formulae (C-2-1) to (C-2-4); structural units represented by the following formulae (C-4-1) to (C-4-4); and the like, in which at least one hydroxy group bonds to the aromatic ring.

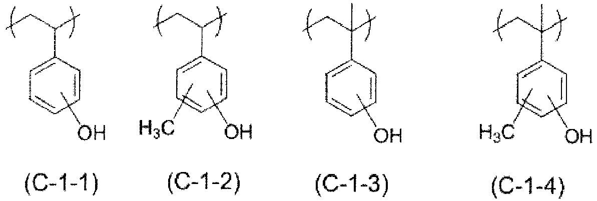

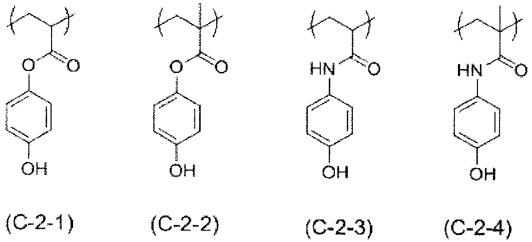

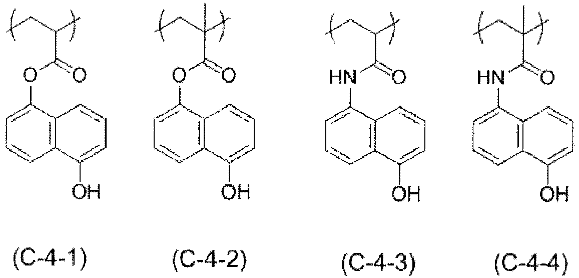

### Structural Unit (X)

The structural unit (X) is: the structural unit (X1) having a hydrocarbon group substituted with an alcoholic hydroxyl group, a carboxy group, a cyano group and/or a sulfo group, or substituted with a group that is capable of generating an alcoholic hydroxyl group, a carboxy group and/or a sulfo group by an action of an acid or upon irradiation with a radioactive ray, or a combination thereof; the structural unit (X2) having a lactone structure, a cyclic carbonate structure, a sultone structure or a combination thereof; or a combination thereof. The structural unit (X) may be exemplified by: structural units represented by the following formulae (C-5-1) to (C-5-16); structural units represented by the following formulae (C-6-1) to (C-6-18); structural units represented by the following formulae (C-7-1) to (C-7-3); and the like. The structural units represented by the following formulae (C-7-1) to (C-7-3) each comprise the group that is capable of generating an acid upon irradiation with a radioactive ray. The polymer (A) comprising such a group that is capable of generating an acid upon irradiation with a radioactive ray constitutes the acid generator (B).

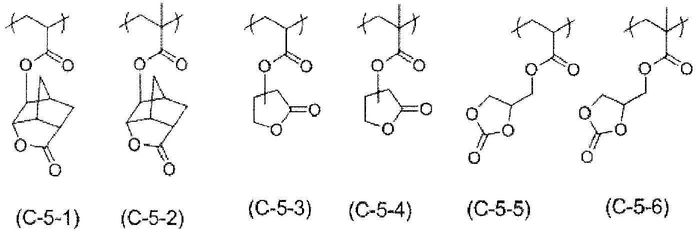

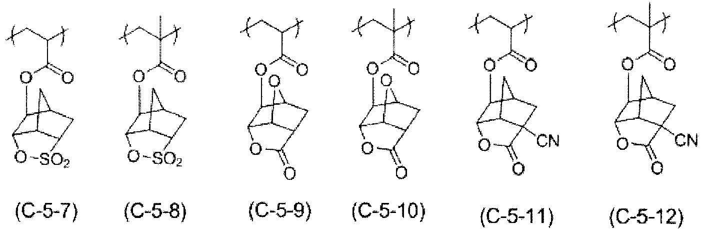

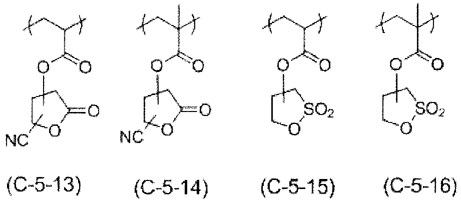

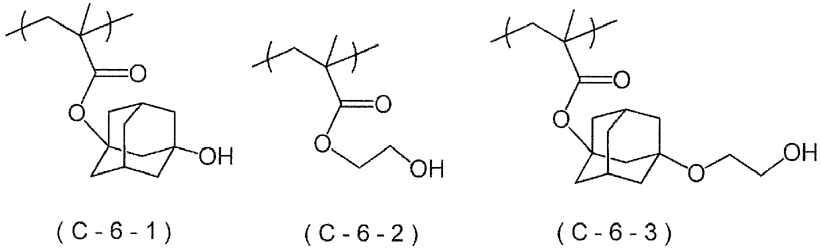

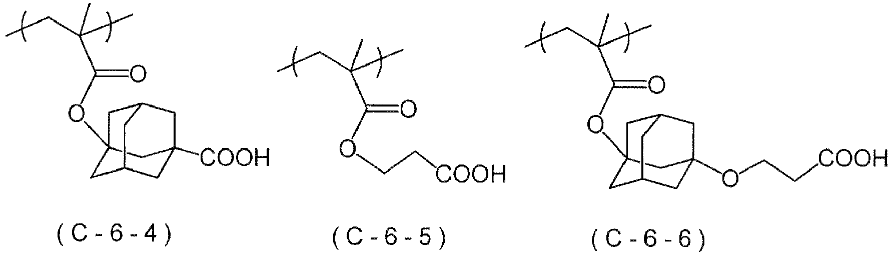

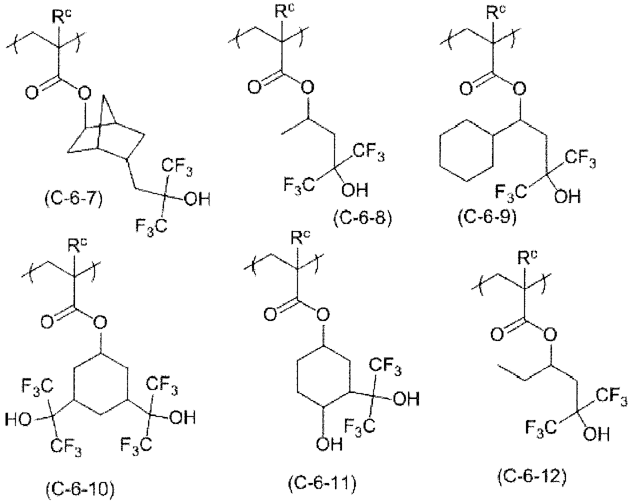

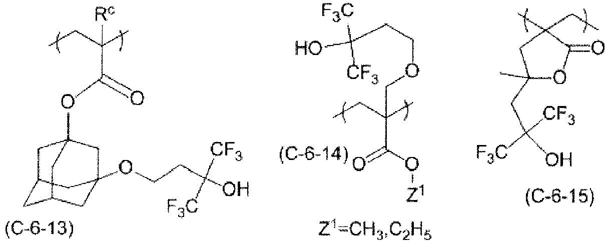

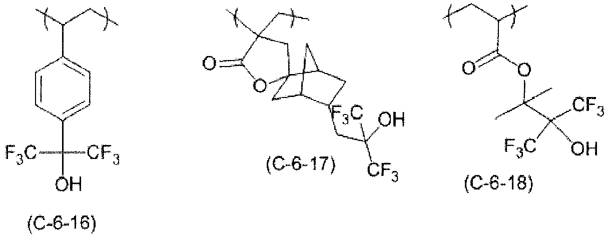

In the above formulae, R^{C} represents a hydrogen atom, a methyl group, or a trifluoromethyl group.

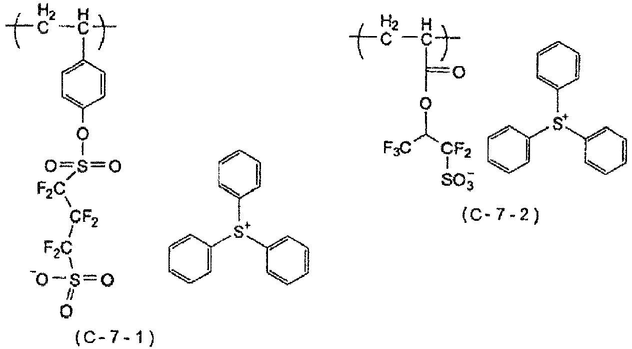

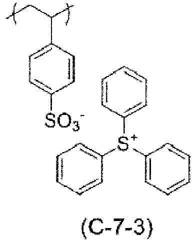

The lower limit of a total proportion of the structural unit (I) contained in the polymer (A) is preferably 10 mol%, more preferably 15 mol%, and still more preferably 20 mol%. The upper limit of the total proportion of the structural unit (I) contained is preferably 80 mol%, and more preferably 70 mol%. When the proportion of the structural unit (I) contained falls within the above range, the photoresist composition is enabled to further satisfy basic characteristics such as a contrast between light-exposed regions and light-unexposed regions.

In the case where the polymer (A) comprises the structural unit (II), the lower limit of a total proportion of the structural unit (II) contained in the polymer (A) is preferably 10 mol%, more preferably 15 mol%, and still more preferably 20 mol%. The upper limit of the total proportion of the structural unit (II) contained is preferably 80 mol%, and more preferably 70 mol%. When the proportion of the structural unit (II) contained falls within the above range, a more appropriate adjustment of a solubility of the polymer (A) in a developer solution is enabled, and an appropriate adjustment in connection with variation of the solubility of the polymer (A) caused by insufficient exposure and insufficient deprotection of the acid-labile group is also enabled.

In the case where the polymer (A) comprises the structural unit (X), the lower limit of a total proportion of the structural unit (X) contained in the polymer (A) is preferably 5 mol%, more preferably 20 mol%, and still more preferably 30 mol%. The upper limit of the total proportion of the structural unit (X) contained is preferably 50 mol%, more preferably 45 mol%, and still more preferably 40 mol%. When the proportion of the structural unit (X) contained falls within the above range, a more appropriate adjustment of the solubility of the polymer (A) in a developer solution is enabled to, and an appropriate adjustment in connection with variation of the solubility of the polymer (A) caused by insufficient exposure and insufficient deprotection of the acid-labile group is also enabled.

The lower limit of a content of the component (A) with respect to the total solid content of the photoresist composition is preferably 70% by mass, more preferably 80% by mass, and still more preferably 85% by mass. The upper limit of the content of the component (A) is, for example, 95% by mass.

### Synthesis Method of (A) Polymer

The polymer (A) can be produced by, for example, polymerizing in an appropriate solvent a monomer corresponding to each predetermined structural unit, by using a radical polymerization initiator. It is preferred that the polymer (A) is synthesized by, for example: carrying out a polymerization reaction by adding dropwise a solution containing the monomer and a radical initiator to a solution containing a reaction solvent or the monomer; carrying out a polymerization reaction by separately adding dropwise a solution containing the monomer and a solution containing the radical initiator to a solution containing the reaction solvent or the monomer; or carrying out a polymerization reaction by separately adding dropwise a plurality of types of solutions containing respective monomers and a solution containing the radical initiator to a solution containing the reaction solvent or the monomer.

The solvent used in the polymerization is exemplified by: alkanes such as n-pentane, n-hexane, n-heptane, n-octane, n-nonane and n-decane; cycloalkanes such as cyclohexane, cycloheptane, cyclooctane, decalin and norbornane; aromatic hydrocarbons such as benzene, toluene, xylene, ethylbenzene and cumene; halogenated hydrocarbons such as chlorobutanes, bromohexanes, dichloroethanes, hexamethylene dibromide and chlorobenzene; saturated carboxylic esters such as ethyl acetate, n-butyl acetate, i-butyl acetate and methyl propionate; ketones such as acetone, 2-butanone, 4-methyl-2-pentanone, 2-heptanone and methyl ethyl ketone; ethers such as tetrahydrofuran, dimethoxyethanes and diethoxyethanes; alcohols such as methanol, ethanol, 1-propanol, 2-propanol and 4-methyl-2-pentanol; and the like. These solvents may be used either alone of one type, or in combination of two or more types thereof.

The lower limit of a reaction temperature for the polymerization is typically 40 °C, and preferably 50 °C. The upper limit of the reaction temperature is typically 150 °C, and preferably 120 °C. The lower limit of a reaction time period is typically 1 hour. The upper limit of the reaction time period is typically 48 hrs, and preferably 24 hrs.

The radical initiator used in the polymerization is exemplified by azobisisobutyronitrile (AIBN), 2,2'-azobis(4-methoxy-2,4-dimethylvaleronitrile), 2,2'-azobis(2-cyclopropylpropionitrile), 2,2'-azobis(2,4-dimethylvaleronitrile), 2,2'-azobis(2-methylpropionitrile), and the like. These radical initiators may be used in combination of two or more types thereof.

The polymer obtained after the polymerization reaction is preferably collected by a reprecipitation technique. In other words, after completion of the polymerization reaction, a polymerization liquid is added to a reprecipitation agent and an intended polymer is collected in a form of powder. As the reprecipitation agent, alcohols, alkanes and the like may be used either alone, or as a mixture of two or more types thereof. The polymer may also be collected by removing low-molecular weight components such as monomers and oligomers by a liquid separation technique, a column technique, an ultrafiltration technique, and the like, in addition to the reprecipitation technique.

The lower limit of the polystyrene equivalent weight average molecular weight (Mw) as determined by gel permeation chromatography (GPC) of the polymer (A) is preferably 1,000, more preferably 3,000, and still more preferably 5,000. The upper limit of Mw is preferably 50,000, more preferably 30,000, and still more preferably 10,000.

The lower limit of the ratio (Mw/Mn) of the Mw to the polystyrene equivalent number average molecular weight (Mn) as determined by GPC of the polymer (A) is typically 1. The upper limit of the ratio is typically 3, and preferably 2.

### (B) Acid Generator

As the acid generator (B) in the photoresist composition, the compound (A) into which the group that is capable of generating an acid upon irradiation with a radioactive ray has been introduced, the acid generating agent (B) that is capable of generating an acid upon irradiation with a radioactive ray, or a combination thereof may be used. The acid generator (B) is a compound that is capable of generating an acid upon irradiation with a radioactive ray such as an extreme ultraviolet ray (EUV) and an electron beam in an exposing step, etc. in a resist pattern-forming method described later. The acid-labile group comprised in the compound (A) is dissociated by an action of the acid, thereby generating a polar group such as a carboxy group and a phenolic hydroxyl group. Consequently, the compound (A) and the like become readily soluble in an alkaline developer solution or hardly soluble in an organic solvent, whereby contrast is enabled to be provided to a resist film.

The acid generating agent (B) is exemplified by an onium salt compound, a sulfonimide compound, a halogen-containing compound, a diazo ketone compound, and the like. Of these, an onium salt compound is preferred.

Exemplary onium salt compound includes a sulfonium salt, a tetrahydrothiophenium salts, an iodonium salt, a phosphonium salt, a diazonium salt, a pyridinium salt, and the like. Of these, a sulfonium salt is preferred.

Examples of the sulfonium salt include: triphenylsulfonium trifluoromethanesulfonate, triphenylsulfonium nonafluoro-n-butanesulfonate, triphenylsulfonium perfluoro-n-octanesulfonate, triphenylsulfonium 2-bicyclo[2.2.1]hept-2-yl-1,1,2,2-tetrafluoroethanesulfonate, triphenylsulfonium camphorsulfonate, 4-cyclohexylphenyldiphenylsulfonium trifluoromethanesulfonate, 4-cyclohexylphenyldiphenylsulfonium nonafluoro-n-butanesulfonate, 4-cyclohexylphenyldiphenylsulfonium perfluoro-n-octanesulfonate, 4-cyclohexylphenyldiphenylsulfonium 2-bicyclo[2.2.1]hept-2-yl-1,1,2,2-tetrafluoroethanesulfonate, 4-cyclohexylphenyldiphenylsulfonium camphorsulfonate, 4-methanesulfonylphenyldiphenylsulfonium trifluoromethanesulfonate, 4-methanesulfonylphenyldiphenylsulfonium nonafluoro-n-butanesulfonate, 4-methanesulfonylphenyldiphenylsulfonium perfluoro-n-octanesulfonate, and 4-methanesulfonylphenyldiphenylsulfonium 2-bicyclo[2.2.1]hept-2-yl-1,1,2,2-tetrafluoroethanesulfonate, 4-methanesulfonylphenyldiphenylsulfonium camphorsulfonate, triphenylsulfonium 2-(1-adamantyl)-1,1-difluoroethanesulfonate, triphenylsulfonium 6-(1-adamantylcarbonyloxy)-1,1,2,2-tetrafluorohexane-1-sulfonate, triphenylsulfonium 6-(1-adamantylcarbonyloxy)-1,1,2-trifluorobutane-1-sulfonate, triphenylsulfonium 2-(4-oxo-1-adamantylcarbonyloxy)-1,1,3,3,3-pentafluoropropane-1-sulfonate, 2-bicyclo[2.2.1]hept-2-yl-1,1-difluoroethanesulfonate, and the like.

Of these, 4-cyclohexylphenyldiphenylsulfonium nonafluoro-n-butanesulfonate, triphenylsulfonium trifluoromethanesulfonate, triphenylsulfonium nonafluoro-n-butanesulfonate, triphenylsulfonium 2-(1-adamantyl)-1,1-difluoroethanesulfonate, triphenylsulfonium 6-(1-adamantylcarbonyloxy)-1,1,2,2-tetrafluorohexane-1-sulfonate, triphenylsulfonium 6-(1-adamantylcarbonyloxy)-1,1,2-trifluorobutane-1-sulfonate, triphenylsulfonium 2-(4-oxo-1-adamantylcarbonyloxy)-1,1,3,3,3-pentafluoropropane-1-sulfonate, and triphenylsulfonium 2-bicyclo[2.2.1]hept-2-yl-1,1-difluoroethanesulfonate are preferred.

Examples of the tetrahydrothiophenium salt include 1-(4-n-butoxynaphthalen-1-yl)tetrahydrothiophenium trifluoromethanesulfonate, 1-(4-n-butoxynaphthalen-1-yl)tetrahydrothiophenium nonafluoro-n-butanesulfonate, 1-(4-n-butoxynaphthalen-1-yl)tetrahydrothiophenium perfluoro-n-octanesulfonate, 1-(4-n-butoxynaphthalen-1-yl)tetrahydrothiophenium 2-bicyclo[2.2.1]hept-2-yl-1,1,2,2-tetrafluoroethanesulfonate, 1-(4-n-butoxynaphthalen-1-yl)tetrahydrothiophenium camphorsulphonate, 1-(6-n-butoxynaphthalen-2-yl)tetrahydrothiophenium trifluoromethanesulfonate, 1-(6-n-butoxynaphthalen-2-yl)tetrahydrothiophenium nonafluoro-n-butanesulfonate, 1-(6-n-butoxynaphthalen-2-yl)tetrahydrothiophenium perfluoro-n-octanesulfonate, 1-(6-n-butoxynaphthalen-2-yl)tetrahydrothiophenium 2-bicyclo[2.2.1]hept-2-yl-1,1,2,2-tetrafluoroethanesulfonate, 1-(6-n-butoxynaphthalen-2-yl)tetrahydrothiophenium camphorsulphonate, 1-(3,5-dimethyl-4-hydroxyphenyl)tetrahydrothiophenium trifluoromethanesulfonate, 1-(3,5-dimethyl-4-hydroxyphenyl)tetrahydrothiophenium nonafluoro-n-butanesulfonate, 1-(3,5-dimethyl-4-hydroxyphenyl)tetrahydrothiophenium perfluoro-n-octanesulfonate, 1-(3,5-dimethyl-4-hydroxyphenyl)tetrahydrothiophenium 2-bicyclo[2.2.1]hept-2-yl-1,1,2,2-tetrafluoroethanesulfonate, 1-(3,5-dimethyl-4-hydroxyphenyl)tetrahydrothiophenium camphorsulfonate, and the like.

Of these, 1-(4-n-butoxynaphthalen-1-yl)tetrahydrothiophenium nonafluoro-n-butanesulfonate, 1-(4-n-butoxynaphthalen-1-yl)tetrahydrothiophenium perfluoro-n-octanesulfonate, 1-(4-n-butoxynaphthalen-1-yl)tetrahydrothiophenium 2-bicyclo[2.2.1]hept-2-yl-1,1,2,2-tetrafluoroethanesulfonate, and 1-(3,5-dimethyl-4-hydroxyphenyl)tetrahydrothiophenium nonafluoro-n-butanesulfonate are preferred.

It is to be noted that, a form of the acid generator (B) in which the group that is capable of generating an acid upon irradiation with a radioactive ray has been incorporated as a part of a polymer is exemplified by the polymer (A) comprising the structural unit represented by the above formulae (C-7-1) or (C-7-2), and the like.

In a case where the photoresist composition contains the acid generating agent (B) as the acid generator (B), the lower limit of a content of the acid generating agent (B) with respect to 100 parts by mass of the compound (A) is typically 0.1 parts by mass and preferably 0.5 parts by mass, in light of ensuring developability of a resist. The upper limit of the content of the acid generating agent (B) is typically 40 parts by mass, and preferably 30 parts by mass. When the content of the acid generating agent (B) is less than 0.1 parts by mass, the developability of a resist tends to be inferior. Meanwhile, the content greater than 40 parts by mass leads to a tendency of failing to obtain a desired resist pattern due to lowered transparency to radioactive rays. In a case where the acid generator (B) is in the form in which the group that is capable of generating an acid upon irradiation with a radioactive ray is incorporated as a part of the polymer (A), the lower limit of the proportion of the structural unit comprising the group that is capable of generating an acid upon irradiation with a radioactive ray contained with respect to the total structural units constituting the polymer (A) is preferably 0.5 mol%, and more preferably 1 mol%. The upper limit of the proportion of the structural unit contained is preferably 30 mol%, and more preferably 20 mol%.

### (C) Particles

The photoresist composition comprises the particles (C). The particles (C) comprise a metal element and have a hydrodynamic radius as determined by the dynamic light scattering analysis being no greater than 20 nm. Although not necessarily clarified, the reason for achieving the effects described above due to the photoresist composition comprising the particles (C) is inferred as in the following. Specifically, by virtue of the particles (C) having the specific hydrodynamic radius, the effect of absorbing exposure light such as EUV is further favorable.

The particles (C) are: a complex obtained by mixing at least one type of organic compound represented by the following formula (L-1), with a metal-containing compound which is the metal compound (I), a hydrolysis product of the metal compound (I), a hydrolytic condensation product of the metal compound (I), or a combination thereof; or a hydrolytic condensation product of the complex. A polynuclear complex is expected to be formed by mixing the metal-containing compound with the organic compound. Due to the particles (C) being used, the effect of absorbing exposure light such as EUV is considered to become further favorable.

R¹-(-X)ₙ (L-1)

In the above formula (L-1): R¹ represents an organic group having a valency of n; X represents -OH, -COOH, -NCO, -NHR^{a}, -COOR^{A}, or -CO-C(R^{L})₂-CO-R^{A}, R^{a} representing a hydrogen atom or a monovalent organic group, R^{A} representing a monovalent organic group, and R^{L} each independently representing a hydrogen atom or a monovalent organic group; and n is an integer of 1 to 4, wherein in a case where n is no less than 2, a plurality of Xs may be identical or different.

### Metal-Containing Compound

The metal-containing compound is: a metal compound (I) comprising a hydrolyzable group; a hydrolysis product of the metal compound (I) comprising a hydrolyzable group; a hydrolytic condensation product of the metal compound (I) comprising a hydrolyzable group; or a combination thereof. The metal compound (I) comprises a hydrolyzable group.

The hydrolyzable group is exemplified by a halogen atom, an alkoxy group, a carboxylate group, and the like.

Examples of the halogen atom include a fluorine atom, a chlorine atom, a bromine atom, an iodine atom, and the like.

Examples of the alkoxy group include a methoxy group, an ethoxy group, a propoxy group, a butoxy group, and the like.

Examples of the carboxylate group include a formate group, an acetate group, a propionate group, a butyrate group, a benzoate group, an oxalate group, a (meth)acrylate group, and the like.

As the hydrolyzable group, an alkoxy group is preferred, and an isopropoxy group and a butoxy group are more preferred.

The metal element is zirconium, hafnium, tantalum, tungsten, iron, zinc, tin, or bismuth.

The metal compound (I) may be used either alone of one type, or in combination of two or more types thereof.

The metal compound (I) comprising the hydrolyzable group as the metal-containing compound is exemplified by compounds represented by the following formula (6) (hereinafter, may be also referred to as a "complex (II)").

LₐMY_{b} (6)

In the above formula (6): M represents a metal element; L represents a ligand; a is 0 to 2, wherein in a case where a is 2, a plurality of Ls may be identical or different; Y represents a hydrolyzable group selected from a halogen atom, an alkoxy group, and a carboxylate group; and b is an integer of 2 to 6, wherein in a case where b is no less than 2, a plurality of Ys may be identical or different. L represents a ligand that does not fall under the definition of Y.

The metal element represented by M is zirconium, hafnium, tantalum, tungsten, iron, zinc, tin, or bismuth.

The ligand represented by L is exemplified by a monodentate ligand and a polydentate ligand.

Exemplary monodentate ligand includes a hydroxo ligand, a carboxy ligand, an amido ligand, and the like.

Examples of the amido ligand include an unsubstituted amido ligand (NH₂), a methylamido ligand (NHMe), a dimethylamido ligand (NMe₂), a diethylamido ligand (NEt₂), a dipropylamido ligand (NPr₂), and the like.

Exemplary polydentate ligand includes a hydroxy acid ester, a β-diketone, a β-ketoester, a β-dicarboxylic acid ester, a hydrocarbon having a π bond, a diphosphine, a carboxylic acid compound, ammonia, and the like.

Examples of the hydroxy acid ester include glycolic acid esters, lactic acid esters, 2-hydroxycyclohexane-1-carboxylic acid esters, salicylic acid esters, and the like.

Examples of the β-diketone include acetylacetone, methylacetylacetone, ethyl acetyl acetone, 3-methyl-2,4-pentanedione, and the like.

Examples of the β-ketoester include acetoacetic acid esters, α-alkyl-substituted acetoacetic acid esters, β-ketopentanoic acid esters, benzoylacetic acid esters, 1,3-acetonedicarboxylic acid esters, and the like.

Examples of the β-dicarboxylic acid ester include malonic acid diesters, α-alkyl-substituted malonic acid diesters, α-cycloalkyl-substituted malonic acid diesters, α-aryl-substituted malonic acid diesters, and the like.

Examples of the hydrocarbon having a π bond include:
chain olefins such as ethylene and propylene;
cyclic olefins such as cyclopentene, cyclohexene and norbornene;
chain dienes such as butadiene and isoprene;
cyclic dienes such as cyclopentadiene, methylcyclopentadiene, pentamethylcyclopentadiene, cyclohexadiene and norbornadiene;
aromatic hydrocarbons such as benzene, toluene, xylene, hexamethylbenzene, naphthalene and indene; and the like.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, and the like.

The carboxylic acid compound is preferably a monocarboxylic acid compound having no less than 6 carbon atoms, examples of which include caprylic acid, caprylic acid, capric acid, stearic acid, benzoic acid, and the like.

Examples of the halogen atom which may be represented by Y include a fluorine atom, a chlorine atom, a bromine atom, an iodine atom, and the like.

Examples of the alkoxy group which may be represented by Y include a methoxy group, an ethoxy group, a propoxy group, a butoxy group, and the like.

As the carboxylate group which may be represented by Y, a formate group and an alkylcarbonyloxy group having 5 or less carbon atoms are preferred. Examples of the alkylcarbonyloxy group having no greater than 5 carbon atoms include an acetate group, a propionate group, a butyrate group, a valerate group, and the like.

As Y, an alkoxy group is preferred, and an isopropoxy group and a butoxy group are more preferred.

In the complex (II), it is preferred that b is 4, and Y represents an alkoxy group.

As the metal-containing compound, a metal alkoxide having been neither hydrolyzed nor hydrolytically condensed is preferred.

Examples of the metal-containing compound include zirconium n-butoxide, zirconium n-propoxide, hafnium ethoxide, hafnium isopropoxide, tantalum pentaethoxide, tungsten methoxide, iron chloride, titanium n-butoxide, titanium n-propoxide, zirconium di-n-butoxide bis(2,4-pentanedionate), titanium tri-n-butoxide stearate, bis(cyclopentadienyl)hafnium dichloride, bis(cyclopentadienyl)tungsten dichloride, diacetato[(S)-(-)-2,2'-bis(diphenylphosphino)-1,1'-binaphtyl]ruthenium, dichloro[ethylenebis[diphenylphosphine]]cobalt, titanium butoxide oligomer, aminopropyltrimethoxytitanium, aminopropyltriethoxyzirconium, 2-(3,4-epoxycyclohexyl)ethyltrimethoxyzirconium, γ-glycidoxypropyltrimethoxyzirconium, 3-isocyanopropyltrimethoxyzirconium, 3-isocyanopropyltriethoxyzirconium, triethoxymono(acetylacetonato)titanium, tri-n-propoxymono(acetylacetonato)titanium, tri-i-propoxymono(acetylacetonato)titanium, triethoxymono(acetylacetonato)zirconium, tri-n-propoxymono(acetylacetonato)zirconium, tri-i-propoxymono(acetylacetonato)zirconium, titanium tributoxymonostearate, diisopropoxybis acetyl acetonate, di-n-butoxybis(acetylacetonate)titanium, di-n-butoxybis(acetylacetonate)zirconium, tri(3-methacryloxypropyl)methoxyzirconium, tri(3-acryloxypropyl)methoxyzirconium, zinc chloride, butyltin trichloride, bismuth chloride, and the like.

### Organic Compound

The organic compound is represented by the following formula (L-1).

R¹-(-X)ₙ (L-1)

In the above formula (L-1), R¹, X and n are as defined above.

The organic group having a valency of n which is represented by R¹ is exemplified by: a hydrocarbon group having a valency of n; a group containing a hetero atom that has a valency of n and includes between two carbon atoms in the hydrocarbon group, a group comprising a hetero atom; a group having a valency of n which is obtained by substituting a part or all of hydrogen atoms included in the hydrocarbon group or the group containing a hetero atom with a substituent; and the like.

Examples of the hydrocarbon group having a valency of n include groups obtained by removing n hydrogen atoms from hydrocarbons such as
chain hydrocarbons having 1 to 30 carbon atoms such as: alkanes, e.g., methane, ethane, propane and butane; alkenes, e.g., ethene, propene, butene and pentene; and alkynes, e.g., ethyne, propyne, butyne and pentyne,
alicyclic hydrocarbons having 3 to 30 carbon atoms such as: cycloalkanes, e.g., cyclopropane, cyclobutane, cyclopentane, cyclohexane, norbornane and adamantane; and cycloalkenes, e.g., cyclopropene, cyclobutene, cyclopentene, cyclohexene and norbornene, and
aromatic hydrocarbons having 6 to 30 carbon atoms such as: arenes, e.g., benzene, toluene, xylene, mesitylene, naphthalene, methylnaphthalene, dimethylnaphthalene and anthracene,
and the like.

The group comprising a hetero atom is exemplified by groups that include at least one selected from the set consisting of an oxygen atom, a nitrogen atom, a silicon atom, a phosphorus atom and a sulfur atom, and the like, and examples thereof include -O-, -NH-, -CO-, -S-, a combination thereof, and the like. Of these, -O- is preferred.

Examples of the substituent include:
halogen atoms such as a fluorine atom, a chlorine atom, a bromine atom and an iodine atom;
alkoxy groups such as a methoxy group, an ethoxy group and a propoxy group;
alkoxycarbonyl groups such as a methoxycarbonyl group and an ethoxycarbonyl group;
alkoxycarbonyloxy groups such as a methoxycarbonyloxy group and an ethoxycarbonyloxy group;
acyl groups such as a formyl group, an acetyl group, a propionyl group, a butyryl group and a benzoyl group; a cyano group, and a nitro group; and the like.

The monovalent organic group which is represented by R^{a} in the -NHR^{a} is exemplified by: a monovalent hydrocarbon group having 1 to 20 carbon atoms; a group comprising a hetero atom that includes between two carbon atoms in the hydrocarbon group, a group comprising a hetero atom; a group which is obtained by substituting a part or all of hydrogen atoms included in the hydrocarbon group or the group containing a hetero atom with a substituent; and the like. R^{a} represents preferably a monovalent hydrocarbon group, more preferably a monovalent chain hydrocarbon group, still more preferably an alkyl group, and particularly preferably a methyl group.

The monovalent organic group represented by R^{A} in the -COOR^{A} and -CO-C(R^{L})₂-CO-R^{A} is exemplified by monovalent organic groups similar to those exemplified in connection with the R^{a}.

The monovalent organic group represented by R^{L} in the -CO-C(R^{L})₂-CO-R^{A} is exemplified by monovalent organic groups similar to those exemplified in connection with the R^{a}. It is to be noted that two R^{L}s may be identical or different.

When n is 1, the R¹ represents preferably a monovalent chain hydrocarbon group, a monovalent aromatic hydrocarbon group or a monovalent group containing a hetero atom, more preferably an alkyl group or an alkenyl group, and still more preferably a propyl group or a 2-propenyl group.

When n is 2, R¹ represents preferably a divalent chain hydrocarbon group, a divalent aromatic hydrocarbon group, or a divalent group containing a hetero atom, more preferably an alkanediyl group, an alkenediyl group, an arenediyl group, or an alkanediyloxyalkanediyl group, and still more preferably a 1,2-ethanediyl group, a 1,2-propanediyl group, a butanediyl group, a hexanediyl group, an ethenediyl group, a xylenediyl group, or an ethanediyloxyethanediyl group.

When n is 3, R¹ represents preferably a trivalent chain hydrocarbon group, more preferably an alkanetriyl group, and still more preferably a 1,2,3-propanetriyl group.

When n is 4, R¹ represents preferably a tetravalent chain hydrocarbon group, more preferably an alkanetetrayl group, and still more preferably a 1,2,3,4-butanetetrayl group.

Examples of the organic compound represented by the above formula (L-1) include compounds represented by the following formulae (L-1-1) to (L-1-6) (hereinafter, may be also referred to as "compounds (L-1-1) to (L-1-6)"), and the like.

R¹-(-OH)ₙ (L-1-1)

R¹-(-COOH)ₙ (L-1-2)

R¹-(-NCO)ₙ (L-1-3)

R¹-(-NHR^{a})ₙ (L-1-4)

R¹-(-COOR^{A})ₙ (L-1-5)

R¹-(-COC(R^{L})₂COR^{A})ₙ (L-1-6)

In the above formulae (L-1-1) to (L-1-6), R¹, R^{a}, R^{A}, R^{L}, and n are as defined for the above formula (L-1).

As the compound (L-1-1), the compound (L-1-1) in which n is 2 to 4 is preferred, examples of which include
when n is 2:
alkylene glycols such as ethylene glycol, propylene glycol, butylene glycol and hexamethylene glycol;
dialkylene glycols such as diethylene glycol, dipropylene glycol, dibutylene glycol, triethylene glycol and tripropylene glycol;
cycloalkylene glycols such as cyclohexanediol, cyclohexanedimethanol, norbornanediol, norbornanedimethanol and adamantanediol;
aromatic ring-containing glycols such as 1,4-benzenedimethanol and 2,6-naphthalenedimethanol;
divalent phenols such as catechol, resorcinol and hydroquinone; and the like,
when n is 3:
   alkanetriols such as glycerin and 1,2,4-butanetriol;
   cycloalkanetriols such as 1,2,4-cyclohexanetriol and 1,2,4-cyclohexanetrimethanol;
   aromatic ring-containing glycols such as 1,2,4-benzenetrimethanol and 2,3,6-naphthalenetrimethanol;
   trivalent phenols such as pyrogallol and 2,3,6-naphthalenetriol;
   trimethylolpropane ethoxylate; and the like,
   when n is 4:
      alkanetetraols such as erythritol and pentaerythritol;
      cycloalkanetetraols such as 1,2,4,5-cyclohexanetetraol;
      aromatic ring-containing tetraols such as 1,2,4,5-benzenetetramethanol;
      tetravalent phenols such as 1,2,4,5-benzenetetraol; and the like.

Of these, the compounds (1-1) in which n is 2 or 3 are preferred, alkylene glycols, dialkylene glycols, alkanetriols and trimethylolpropane ethoxylate are more preferred, and propylene glycol, diethylene glycol, glycerin and trimethylolpropane ethoxylate are still more preferred.

Examples of the compound (L-1-2) include,
when n is 1:
chain saturated monocarboxylic acids such as acetic acid and propionic acid;
unsaturated monocarboxylic acids such as acrylic acid, methacrylic acid and trans-2,3-dimethylacrylic acid;
alicyclic monocarboxylic acids such as cyclohexanedicarboxylic acid, norbornanecarboxylic acid and adamantanecarboxylic acid;
aromatic monocarboxylic acids such as benzoic acid and naphthalenecarboxylic acid; and the like,
when n is 2:
   chain saturated dicarboxylic acids such as oxalic acid, malonic acid, succinic acid, glutaric acid and adipic acid;
   chain unsaturated dicarboxylic acids such as maleic acid, fumaric acid and trans-2,3-dimethylacrylic acid;
   alicyclic dicarboxylic acids such as 1,4-cyclohexanedicarboxylic acid, norbornanedicarboxylic acid and adamantanedicarboxylic acid;
   aromatic dicarboxylic acids such as phthalic acid, terephthalic acid, 2,6-naphthalenedicarboxylic acid and 2,7-naphthalenedicarboxylic acid; and the like,
   when n is 3:
      chain saturated tricarboxylic acids such as 1,2,3-propanetricarboxylic acid;
      chain unsaturated tricarboxylic acids such as 1,2,3-propenetricarboxylic acid;
      alicyclic tricarboxylic acids such as 1,2,4-cyclohexanetricarboxylic acid;
      aromatic tricarboxylic acids such as trimellitic acid and 2,3,7-naphthalenetricarboxylic acid; and the like,
      when n is 4:
         chain saturated tetracarboxylic acids such as 1,2,3,4-butanetetracarboxylic acid;
         chain unsaturated tetracarboxylic acids such as 1,2,3,4-butadienetetracarboxylic acid;
         alicyclic tetracarboxylic acids such as 1,2,5,6-cyclohexanetetracarboxylic acid and 2,3,5,6-norbornanetetracarboxylic acid;
         aromatic tetracarboxylic acids such as pyromellitic acid and 2,3,6,7-naphthalenetetracarboxylic acid; and the like. Of these, the compounds (L-1-2) in which n is 1 and 2 are preferred, chain saturated monocarboxylic acids, chain unsaturated monocarboxylic acids, chain saturated dicarboxylic acids and chain unsaturated monocarboxylic acids are more preferred, acetic acid, propionic acid, methacrylic acid, succinic acid, maleic acid and trans-2,3-dimethylacrylic acid are still more preferred, the compounds (L-1-2) in which n is 1 are particularly preferred, and acetic acid, propionic acid, methacrylic acid and trans-2,3-dimethylacrylic acid are still particularly preferred.

As the compound (L-1-3), the compound (L-1-3) in which n is 2 to 4 is preferred, examples of which include
when n is 2:
chain diisocyanates such as ethylene diisocyanate, trimethylene diisocyanate, tetramethylene diisocyanate and hexamethylene diisocyanate;
alicyclic diisocyanates such as 1,4-cyclohexane diisocyanate and isophorone diisocyanate;
aromatic diisocyanates such as tolylene diisocyanate, 1,4-benzene diisocyanate and 4,4'-diphenylmethane diisocyanate; and the like,
when n is 3:
   chain triisocyanates such as trimethylene triisocyanate;
   alicyclic triisocyanates such as 1,2,4-cyclohexane triisocyanate;
   aromatic triisocyanates such as 1,2,4-benzene triisocyanate; and the like,
   when n is 4:
      chain tetraisocyanates such as tetramethylene tetraisocyanate;
      alicyclic tetraisocyanates such as 1,2,4,5-cyclohexane tetraisocyanate;
      aromatic tetraisocyanates such as 1,2,4,5-benzene tetraisocyanate; and the like.

Of these, the compound (L-1-3) in which n is 2 is preferred, chain diisocyanates are more preferred, and hexamethylene diisocyanate is still more preferred.

As the compound (L-1-4), the compound (L-1-4) in which n is 2 to 4 is preferred, examples of which include
when n is 2:
chain diamines such as ethylenediamine, N-methylethylenediamine, N,N'-dimethylethylenediamine, trimethylenediamine, N,N'-dimethyltrimethylenediamine, tetramethylenediamine and N,N'-dimethyltetramethylenediamine;
alicyclic diamines such as 1,4-cyclohexanediamine and 1,4-di(aminomethyl)cyclohexane;
aromatic diamines such as 1,4-diaminobenzene and 4,4'-diaminodiphenylmethane; and the like,
when n is 3:
   chain triamines such as triaminopropane and N,N',N"-trimethyltriaminopropane;
   alicyclic triamines such as 1,2,4-triaminocyclohexane;
   aromatic triamines such as 1,2,4-triaminobenzene; and the like,
   when n is 4:
      chain tetraamines such as tetraaminobutane;
      alicyclic tetraamines such as 1,2,4,5-tetraaminocyclohexane and 2,3,5,6-tetraaminonorbornane;
      aromatic tetraamines such as 1,2,4,5-tetraaminobenzene; and the like. Of these, as the compound (L-1-4), the compound (L-1-4) in which n is 2 is preferred, chain diamines are more preferred, and N,N'-dimethylethylenediamine is still more preferred.

The particles (C) can be suitably synthesized by mixing the metal-containing compound with the organic compound. The mixing can be carried out by a known process.

The lower limit of an amount of the organic compound to be mixed with the metal-containing compound, with respect to 1 mol of a metal comprised in the metal-containing compound is preferably 0.01 mol and more preferably 0.1 mol. The upper limit of the amount of the organic compound to be mixed is preferably 30 mol, more preferably 20 mol, and still more preferably 15 mol.

The lower limit of a temperature for the mixing is preferably 0 °C, and more preferably 10 °C. The upper limit of the temperature for the mixing is preferably 200 °C, and more preferably 150 °C.

The lower limit of a time period for the mixing is preferably 5 min, and more preferably 10 min. The upper limit of the time period for the mixing is preferably 1 week, and more preferably 3 days.

The particles (C) may also be obtained by further mixing a hydroxy acid ester, a β-diketone, a β-ketoester, a β-dicarboxylic acid ester or a combination thereof with a mixture obtained by mixing the metal-containing compound with the organic compound. In this instance, these compounds may be coordinated in a polynuclear complex, which is the particles (C), whereby an improvement of the solubility of the particles (C) in the solvent (S) is expected.

Other compound may also be mixed into the particles (C), as a component constituting the complex in addition to the metal-containing compound and the organic compound, within the range not leading to inhibition of the effects of the present invention. The other compound is exemplified by a silicon compound comprising a hydrolyzable group, a hydrolysis product thereof, a hydrolytic condensation product thereof, and the like. In relation to the upper limit of a content of these compounds, the upper limit of an amount of silicon atom comprised in these compounds with respect to 1 mol of metal atom comprised in the metal-containing compound is preferably 1 mol, more preferably 0.5 mol, and still more preferably 0.1 mol.

The hydroxy acid ester is not particularly limited as long as it is a carboxylic acid ester comprising a hydroxy group, and examples thereof include a compound represented by the following formula (7), and the like.

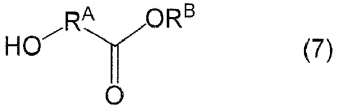

In the above formula (7), R^{A} represents a divalent organic group having 1 to 20 carbon atoms; and R^{B} represents a monovalent organic group having 1 to 20 carbon atoms.

Examples of the divalent organic group represented by R^{A} include organic groups in which n is 2 and having 1 to 20 carbon atoms among those exemplified in connection with the monovalent organic group represented by R¹ in the above formula (L-1), and the like. Examples of the monovalent organic group represented by R^{B} include groups similar to those exemplified in connection with the monovalent organic group represented by R^{a} in the above formula (L-1), and the like.

Examples of the hydroxy acid ester include glycolic acid esters, lactic acid esters, 2-hydroxycyclohexane-1-carboxylic acid esters, salicylic acid esters, and the like. Of these, lactic acid esters are preferred and ethyl lactate is more preferred.

The β-diketone is not particularly limited as long as it is a compound comprising a 1,3-diketo structure, and examples thereof include a compound represented by the following formula (8), and the like.

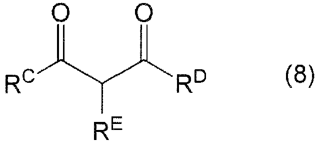

In the above formula (8), R^{C} and R^{D} each independently represent a monovalent organic group having 1 to 20 carbon atoms; and R^{E} represents a hydrogen atom or a monovalent organic group having 1 to 20 carbon atoms.

Examples of the monovalent organic group which may be represented by R^{C}, R^{D}, and R^{E} include groups similar to those exemplified in connection with the monovalent organic group represented by R^{a} in the above formula (L-1), and the like.

Examples of the β-diketone include acetylacetone, methylacetylacetone, ethylacetylacetone, and the like. Of these, acetylacetone is preferred.

The β-ketoester is not particularly limited as long as it is a compound comprising a ketonic carbonyl group at the β position of a carboxylic acid ester, and examples thereof include a compound represented by the following formula (9), and the like.

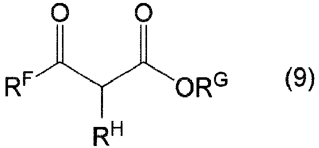

In the above formula (9), R^{F} and R^{G} each independently represent a monovalent organic group having 1 to 20 carbon atoms; and R^{H} represents a hydrogen atom or a monovalent organic group having 1 to 20 carbon atoms.

Examples of the monovalent organic group having 1 to 20 carbon atoms which may be represented by R^{F}, R^{G}, and R^{H} include groups similar to those exemplified in connection with the monovalent organic group represented by R^{a} in the above formula (L-1), and the like.

Examples of the β-ketoester include acetoacetic acid esters, α-alkyl-substituted acetoacetic acid esters, β-ketopentanoic acid esters, benzoylacetic acid esters, 1,3-acetonedicarboxylic acid diesters, and the like. Of these, acetoacetic acid esters and 1,3-acetonedicarboxylic acid diesters are preferred, and ethyl acetoacetate and diethyl-1,3-acetonedicarboxylate are more preferred.

The β-dicarboxylic acid ester is not particularly limited as long as it is a compound having a structure in which two ester groups bind to an identical carbon atom, and examples thereof include a compound represented by the following formula (10), and the like.

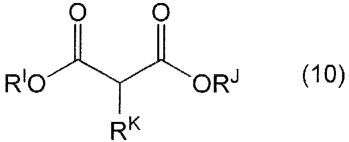

In the above formula (10), R^{I} and R^{J} each independently represent a monovalent organic group having 1 to 20 carbon atoms; and R^{K} represents a hydrogen atom or a monovalent organic group having 1 to 20 carbon atoms.

Examples of the monovalent organic group having 1 to 20 carbon atoms which may be represented by R^{I}, R^{J}, and R^{K} include groups similar to those exemplified in connection with the monovalent organic group represented by R^{a} in the above formula (1), and the like.

Examples of the β-dicarboxylic acid ester include malonic acid diesters, α-alkyl-substituted malonic acid diesters, α-cycloalkyl-substituted malonic acid diesters, α-aryl-substituted malonic acid diesters, and the like. Of these, malonic acid diesters are preferred and diethyl malonate is more preferred.

The lower limit of an amount of the compound, which is a hydroxy acid ester, a β-diketone, a β-ketoester, a β-dicarboxylic acid ester or a combination thereof, to be mixed into the particles (C) is preferably 0.01 mol and more preferably 0.1 mol with respect to 1 mol of the metal comprised in the particles (C). The upper limit of the amount of the compound to be mixed is preferably 1,000 mol, more preferably 100 mol, and still more preferably 50 mol.

The lower limit of a temperature for the mixing is preferably 0 °C, and more preferably 10 °C. The upper limit of the temperature for the mixing is preferably 200 °C, and more preferably 150 °C.

The lower limit of a time period for the mixing is preferably 1 min, and more preferably 5 min. The upper limit of the time period for the mixing is preferably 48 hrs, and more preferably 24 hrs.

The upper limit of a content of the particles (C) in the photoresist composition with respect to 100 parts by mass of the compound (A) is preferably 20 parts by mass, more preferably 15 parts by mass, and still more preferably no greater than 10 parts by mass. The lower limit of the content of the particles (C) is preferably 0.1 parts by mass, more preferably 0.5 parts by mass, and still more preferably 1 part by mass.

The upper limit of a hydrodynamic radius of the particles (C) as determined by the dynamic light scattering analysis is 20 nm, preferably 17 nm, more preferably 14 nm, and particularly preferably 10 nm. The lower limit of the hydrodynamic radius is preferably 0.01 nm, more preferably 0.1 nm, still more preferably 0.3 nm, particularly preferably 0.5 nm, still particularly preferably 0.8 nm, and most preferably 1.0 nm. When the hydrodynamic radius of the particles (C) as determined by the dynamic light scattering analysis falls within the above range, a pattern having less nanoedge roughness and a higher resolution is enabled to be obtained. It is to be noted that the hydrodynamic radius as determined by the dynamic light scattering analysis can be determined by, for example, measurement (DLS measurement) using a light scattering measurement apparatus ("ALV-5000", available from ALV-GmbH, Germany).

Upon production of the photoresist composition, the particles (C) are preferably used in a liquid form in which the particles (C) are dispersed in the solvent (S) described below.

### (S) Solvent

The solvent (S) is exemplified by: protic solvents such as propylene glycol monomethyl ether, propylene glycol monoethyl ether, propylene glycol monopropyl ether, ethyl lactate and n-butanol; and aprotic solvents such as ethyl acetate, butyl acetate, cyclohexanone, γ-butyrolactone, propylene glycol monomethyl ether acetate and tetrahydrofuran. The solvent (S) may be used in combination of two or more types thereof.

In light of stability of the particles, the solvent (S) is preferably an aprotic solvent, more preferably an aprotic solvent comprising a hetero atom, and still more preferably an aprotic solvent comprising an oxygen atom.

A part or an entirety of the solvent (S) may be left and used as the solvent (G) for the photoresist composition, or the entirety of the solvent (S) may be subjected to solvent substitution, etc. with the solvent (G) such that the photoresist composition does not contain the solvent (S).

### (G) Solvent

The solvent (G) used in the photoresist composition is not particularly limited as long as the solvent (G) is able to dissolve at least the compound (A), the particles (C), and other optional components described later. The solvent (G) is exemplified by an alcohol solvent, an ether solvent, a ketone solvent, an amide solvent, an ester solvent, a mixed solvent thereof, and the like.

Specific examples of the solvent (G) are as follows.

Examples of the alcohol solvent include:
monohydric alcohol solvents such as methanol, ethanol, n-propanol, iso-propanol, n-butanol, iso-butanol, sec-butanol, tert-butanol, n-pentanol, iso-pentanol, 2-methylbutanol, sec-pentanol, tert-pentanol, 3-methoxybutanol, n-hexanol, 2-methylpentanol, 4-methyl-2-pentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, furfuryl alcohol, phenol, cyclohexanol, methylcyclohexanol, 3,3,5-trimethylcyclohexanol, benzyl alcohol and diacetone alcohol;
polyhydric alcohol solvents such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol and tripropylene glycol;
polyhydric alcohol partially etherated solvents such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether and dipropylene glycol monopropyl ether; and the like.

Of these, 4-methyl-2-pentanol is preferred.

Examples of the ether solvent include:
chain ether solvents such as dipropyl ether, diisopropyl ether, butyl methyl ether, butyl ethyl ether, butyl propyl ether, dibutyl ether, diisobutyl ether, tert-butyl-methyl ether, tert-butyl ethyl ether, tert-butyl propyl ether, di-tert-butyl ether, dipentyl ether, diisoamyl ether, cyclopentyl methyl ether, cyclohexyl methyl ether, cyclopentyl ethyl ether, cyclohexyl ethyl ether, cyclopentyl propyl ether, cyclopentyl-2-propyl ether, cyclohexyl propyl ether, cyclohexyl-2-propyl ether, cyclopentyl butyl ether, cyclopentyl-tert-butyl ether, cyclohexyl butyl ether, cyclohexyl-tert-butyl ether, anisole, diethyl ether and diphenyl ether;
cyclic ether solvents such as tetrahydrofuran and dioxane; and the like.

Of these, diisoamyl ether is preferred.

Examples of the ketone solvent include:
chain ketone solvents such as acetone, methyl ethyl ketone, methyl n-propyl ketone, methyl n-butyl ketone, diethyl ketone, methyl iso-butyl ketone, methyl n-amyl ketone, ethyl n-butyl ketone, methyl n-hexyl ketone, di-iso-butyl ketone, trimethylnonanone, 2,4-pentane dione, acetonyl acetone and acetophenone;
cyclic ketone solvents such as cyclopentanone, cyclohexanone, cycloheptanone, cyclooctanone and methylcyclohexanone; and the like.

Examples of the amide solvent include:
chain amide solvents such as N-methylformamide, N,N-dimethylformamide, N,N-diethylformamide, acetamide, N-methylacetamide, N,N-dimethylacetamide and N-methylpropionamide;
cyclic amide solvents such as N,N'-dimethylimidazolidinone and N-methylpyrrolidone; and the like.

Examples of the ester solvent include:
carbonate solvents such as dimethyl carbonate, diethyl carbonate, ethylene carbonate and propylene carbonate;
lactone solvents such as γ-butyrolactone and γ-valerolactone;
acetic acid ester solvents such as methyl acetate, ethyl acetate, n-propyl acetate, iso-propyl acetate, n-butyl acetate, iso-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate and n-nonyl acetate;
acetoacetic acid ester solvents such as methyl acetoacetate and ethyl acetoacetate;
polyhydric alcohol partially etherated carboxylate solvents such as ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate and dipropylene glycol monoethyl ether acetate;
propionic acid ester solvents such as ethyl propionate, n-butyl propionate and iso-amyl propionate;
oxalic acid ester solvents such as diethyl oxalate and di-n-butyl oxalate;
lactic acid ester solvents such as methyl lactate, ethyl lactate, n-butyl lactate and n-amyl lactate;
glycol diacetate; methoxytriglycol acetate; diethyl malonate; dimethyl phthalate; diethyl phthalate; and the like.

Examples of hydrocarbon solvent include:
aliphatic hydrocarbon solvents such as n-pentane, iso-pentane, n-hexane, iso-hexane, n-heptane, iso-heptane, 2,2,4-trimethylpentane, n-octane, iso-octane, cyclohexane and methylcyclohexane;
aromatic hydrocarbon solvents such as benzene, toluene, xylene, mesitylene, ethylbenzene, trimethylbenzene, methylethylbenzene, n-propylbenzene, iso-propylbenzene, diethylbenzene, iso-butylbenzene, triethylbenzene, di-iso-propylbenzene and n-amylnaphthalene; and the like.

Of these, the ester solvents and the ketone solvents are preferred, the polyhydric alcohol partial ether carboxylate solvents, the lactic ester solvents and the cyclic ketone solvents are more preferred, and propylene glycol monomethyl ether acetate, ethyl lactate and cyclohexanone are still more preferred as the solvent (G). These solvents (G) may be used either alone of one type, or in combination of two or more types thereof.

The lower limit of a percentage content of the aprotic solvent in the solvent (G) is preferably 70% by mass, more preferably 80% by mass, and still more preferably 90% by mass. The upper limit of the percentage content of the solvent (G) is, for example, 100 % by mass. Of the aforementioned solvents (G), examples of the aprotic solvent include ethyl acetate, butyl acetate, cyclohexanone, γ-butyrolactone, propylene glycol monomethyl ether acetate, and the like.

The solvent (G) may contain no protic solvent (i.e. a percentage content of the protic solvent in the solvent (G) is 0% by mass). The lower limit of a percentage content of the protic solvent in the solvent (G) is preferably 5% by mass, and still more preferably 8% by mass. The upper limit of the percentage content of the protic solvent is preferably 30% by mass, more preferably 20% by mass, and still more preferably 10% by mass. Of the aforementioned solvents (G), examples of the protic solvent include propylene glycol monomethyl ether, propylene glycol monoethyl ether, propylene glycol monopropyl ether, ethyl lactate, n-butanol, and the like.

### Other Optional Component

The photoresist composition may contain an acid diffusion controller, a surfactant, an alicyclic skeleton-containing compound, a sensitizing agent and the like as other optional component. It is to be noted that the photoresist composition may contain either only a single type, or two or more types, of the other optional components.

### Acid Diffusion Controller

The acid diffusion controller is a component that achieves the effect of controlling a diffusion phenomenon of the acid generated from the acid generator upon an exposure in the resist film, and inhibiting unfavorable chemical reactions at light-unexposed regions. Due to the acid diffusion controller contained in the photoresist composition, storage stability of the resulting photoresist composition is further improved and a resolution for use as a resist is further improved. In addition, variation of the line width of the resist pattern caused by variation of post exposure time delay from the exposure until a development process can be inhibited, which enables a composition with extremely superior process stability to be obtained. The acid diffusion controller may be contained in the photoresist composition in the form of a free compound (hereinafter, may be also referred to as "acid diffusion control agent" as appropriate), or in the form incorporated as a part of a polymer, or in both of these forms.

The acid diffusion control agent is exemplified by an amine compound, an amide group-containing compound, a urea compound, a nitrogen-containing heterocyclic compound, and the like.

Examples of the amine compound include mono(cyclo)alkylamines; di(cyclo)alkylamines; tri(cyclo)alkylamines; substituted alkylanilines or derivatives thereof; ethylenediamine, N,N,N',N' -tetramethyl ethyl enediamine, tetramethylenediamine, hexamethylenediamine, 4,4'-diaminodiphenylmethane, 4,4'-diaminodiphenylether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis(1-(4-aminophenyl)-1-methylethyl)benzene, 1,3-bis(1-(4-aminophenyl)-1-methylethyl)benzene, bis(2-dimethylaminoethyl)ether, bis(2-diethylaminoethyl)ether, 1-(2-hydroxyethyl)-2-imidazolidinone, 2-quinoxalinol, N,N,N' ,N' -tetrakis(2-hydroxypropyl)ethylenediamine, N,N,N',N",N"-pentamethyldiethylenetriamine, triethanolamine, and the like. Of these, triethanolamine is preferred.

Examples of the amide group-containing compound include N-t-butoxy carbonyl group-containing amino compounds, formamide, N-methylformamide, N,N-dimethylformamide, acetamide, N-methylacetamide, N,N-dimethylacetamide, propionamide, benzamide, pyrrolidone, N-methylpyrrolidone, N-acetyl-1-adamantylamine, tris(2-hydroxyethyl)isocyanurate, and the like.

Examples of the urea compound include urea, methylurea, 1,1-dimethylurea, 1,3-dimethylurea, 1,1,3,3-tetramethylurea, 1,3-diphenylurea, tri-n-butylthiourea, and the like.

Examples of the nitrogen-containing heterocyclic compound include: imidazoles; pyridines; piperazines; pyrazine, pyrazole, pyridazine, quinoxaline, purine, pyrrolidine, piperidine, N-(t-amyloxycarbonyl)-4-hydroxypiperidine, piperidineethanol, 3-piperidino-1,2-propanediol, morpholine, N-(t-butoxycarbonyl)-2-hydroxymethylpyrrolidine, 4-methylmorpholine, 1-(4-morpholinyl)ethanol, 4-acetylmorpholine, 3-(N-morpholino)-1,2-propanediol, 1,4-dimethylpiperazine, 1,4-diazabicyclo[2.2.2]octane, N-(t-butoxycarbonyl)-2-phenylbenzoimidazole, and the like.

Of these, N-(t-amyloxycarbonyl)-4-hydroxypiperidine, N-(t-butoxycarbonyl)-2-hydroxymethylpyrrolidine, N-(t-butoxycarbonyl)-2-phenylbenzoimidazole, and 2,4,5-triphenylimidazole are preferred.

Alternatively, as the acid diffusion control agent, a photodegradable base that is capable of generating a weak acid through photosensitization upon an exposure may also be used. The photodegradable base is able to generate an acid in light-exposed regions, thereby enabling an insolubility of the polymer (A) in a developer solution to be improved. On the other hand, the photodegradable base serves as a quencher in light-unexposed regions by virtue of an anion exhibiting a superior acid trapping function, thereby trapping the acid that is diffused from the light-exposed regions. In other words, since the photodegradable base serves as a quencher only in the light-unexposed regions, a contrast of a deprotection reaction is improved, thus in turn enabling the resolution to be further improved. The photodegradable base is exemplified by onium salt compounds that lose acid diffusion controllability through decomposition upon an exposure, and the like. Examples of the onium salt compound include a sulfonium salt compound represented by the following formula (11), an iodonium salt compound represented by the following formula (12), and the like.

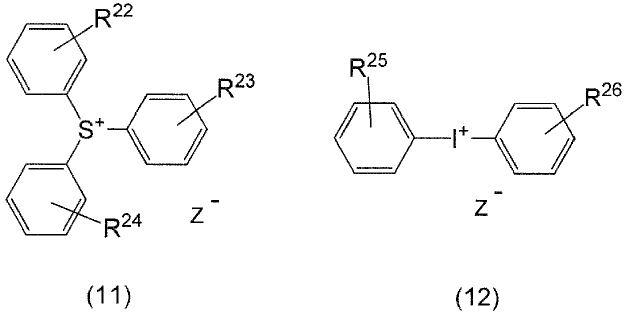

In the above formulae (11) and (12): R²² to R²⁶ each independently represent a hydrogen atom, an alkyl group, an alkoxy group, a hydroxyl group, a hydrogen atom, or -SO₂-R^{C}, wherein R^{C} represents an alkyl group, a cycloalkyl group, an alkoxy group, or an aryl group; Z⁻ represents OH⁻, R²⁷-COO⁻, R^{D}-SO₂-N⁻-R²⁷, R²⁷-SO₃⁻ or an anion represented by the following formula (13), wherein R²⁷ represents a linear or branched alkyl group having 1 to 10 carbon atoms, a cycloalkyl group having 3 to 20 carbon atoms, an aryl group having 6 to 30 carbon atoms, or an aralkyl group having 7 to 30 carbon atoms, wherein a part or all of hydrogen atoms in the alkyl group, the cycloalkyl group, the aryl group, and the aralkyl group may be substituted, and R^{D} represents a linear or branched alkyl group having 1 to 10 carbon atoms, or a cycloalkyl group having 3 to 20 carbon atoms which may comprise a substituent, wherein a part or all of hydrogen atoms in the alkyl group and the cycloalkyl group may be substituted with a fluorine atom, and in a case where Z⁻ represents R²⁷-SO₃⁻, a fluorine atom does not bind to a carbon atom to which SO₃⁻ binds.

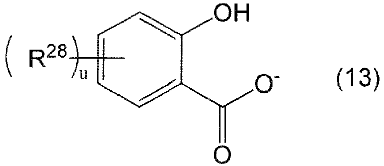

In the above formula (13), R²⁸ represents a linear or branched alkyl group having 1 to 12 carbon atoms, or a linear or branched alkoxy group having 1 to 12 carbon atoms, wherein a part or all of hydrogen atoms included in the linear or branched alkyl group or the linear or branched alkoxy group may be substituted with a fluorine atom; and u is an integer of 0 to 2.

Examples of the photolabile base include compounds represented by the following formulae, and the like.

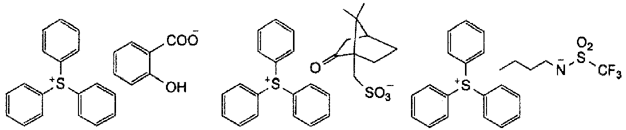

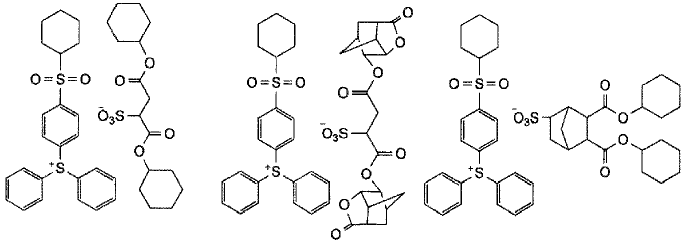

In a case where the photoresist composition contains the acid diffusion control agent as the acid diffusion controller, the upper limit of a content of the acid diffusion control agent in the photoresist composition with respect to 100 parts by mass of the compound (A) is preferably 15 parts by mass, and preferably 10 parts by mass. When the content of the acid diffusion control agent is greater than 15 parts by mass, sensitivity of the resist tends to decrease. The lower limit of the content of the acid diffusion control agent is preferably 0.1 parts by mass, and more preferably 1 part by mass. These acid diffusion control agents may be used either alone of one type, or in combination of two or more types thereof.

### Surfactant

The surfactant achieves the effect of improving application properties, striation, developability, and the like of the photoresist composition.

### Alicyclic Skeleton-Containing Compound

The alicyclic skeleton-containing compound achieves the effect of improving dry etching resistance, a pattern configuration, adhesiveness to a substrate, and the like of the photoresist composition.

### Sensitizing Agent

The sensitizing agent exhibits the action of increasing the amount of the acid generated from the acid generator (B) or the like, and achieves the effect of improving "apparent sensitivity" of the photoresist composition.

### Preparation Method of Photoresist Composition

The photoresist composition can be prepared by, for example, mixing the compound (A), the particles (C), the optional component and the like in the solvent, at a certain ratio. The photoresist composition may be prepared and used in a state of being dissolved or dispersed in an appropriate solvent.

As to the particles (C), mixing with other components in a liquid in which the particles (C) have been dispersed in the solvent (S) is preferred in light of enabling a more homogeneous photoresist composition to be easily obtained. When particles in a state of a solid having a great particle diameter are mixed, problems may arise of the particles being destabilized under influence of other components such as the polymer and the photoacid generating agent in the photoresist composition, or of difficulty in homogeneous mixing. In this regard, due to comprising dispersing in the solvent (S) the particles (C) in a state of a solid, the preparation method of the photoresist composition enables the particles (C) to be dispersed more homogeneously and stably, thus in turn enabling storage stability of the photoresist composition to be further improved.

### Resist Pattern-Forming Method

The resist pattern-forming method according to an embodiment of the present invention comprises: providing a resist film (hereinafter, may be also referred to as "resist film-providing step"); exposing the resist film by irradiating with an extreme ultraviolet ray or an electron beam (hereinafter, may be also referred to as "exposing step"); and developing, with a developer solution, the resist film exposed (hereinafter, may be also referred to as "developing step"). In the resist pattern-forming method, the resist film is provided from the photoresist composition. Hereinafter, each step is described in detail.

### Resist Film-Providing Step

In this step, the resist film is provided. The resist film is provided by applying the aforementioned photoresist composition onto a substrate. As the substrate, a conventionally well-known substrate such as, for example, a silicon wafer and a wafer coated with aluminum may be used. In addition, an organic or inorganic underlayer antireflective film as disclosed in, for example, Japanese Examined Patent Application, Publication No. H6-12452, Japanese Unexamined Patent Application, Publication No. S59-93448, and the like may be formed on the substrate.

Examples of an application method include spin-coating, cast coating, roller coating, and the like. It is to be noted that the lower limit of an average film thickness of the resist film to be provided is typically 10 nm, preferably 20 nm, and more preferably 30 nm. The upper limit of the average film thickness is typically 1,000 nm, preferably 500 nm, and more preferably 100 nm.

The application of the photoresist composition may be followed by prebaking (PB), as needed, for evaporating the solvent in the coating film. The lower limit of a temperature for the PB is appropriately selected in accordance with the composition of the photoresist composition, and is typically 30 °C, and preferably 50 °C. The upper limit of the temperature for the PB is typically approximately 200 °C, and preferably 150 °C.

Furthermore, in order to inhibit an influence of basic impurities, etc., in the environmental atmosphere, for example, a protective film disclosed in Japanese Unexamined Patent Application, Publication No. H5-188598 and the like may be provided on the resist layer.

### Exposure Step

In this step, the resist film is exposed by irradiating with an extreme ultraviolet ray or an electron beam. Exposure conditions such as an exposure dose may be appropriately selected in accordance with the formulation of the photoresist composition used, a type of an additive, and the like. In the case of irradiating with the EUV, for example, reduced projection exposure through a mask having an isoline pattern in a desired region enables an isospace pattern to be formed. In a similar manner, reduced projection exposure through a mask having a dot pattern enables a hole pattern to be formed. The exposure may be carried out two or more times, with mask patterns of desired patterns. In the case of carrying out the exposure two or more times, the exposure is preferably carried out consecutively. In the case of carrying out the exposure multiple times, for example, first reduced projection exposure is carried out in a desired region through a line-and-space pattern mask, followed by second reduced projection exposure such that lines intersect with respect to light-exposed regions having been subjected to the first exposure. The first light-exposed region and the second light-exposed region are preferably orthogonal. The orthogonal arrangement enables a contact hole pattern to be formed in light-unexposed regions surrounded by the light-exposed regions. In the case of irradiating with the electron beam, for example, the exposure is carried out by scanning with the electron beam for irradiation.

The resist pattern-forming method may comprise a plurality of exposure steps as described above, and the radioactive ray (EUV, electron beam) used in the plurality of exposure steps may be either the same or different.

Subsequent to the exposure, post exposure baking (PEB) is preferably carried out. The PEB enables a dissociation reaction of the acid-labile group in the photoresist composition to proceed smoothly. The lower limit of a temperature for the PEB is typically 30 °C, and preferably 50 °C. The upper limit of the temperature for the PEB is typically 200 °C, and preferably 170 °C.

### Development Step

In this step, the resist film exposed is developed with a developer solution. Either of an aqueous alkaline solution and an organic solvent is preferred as the developer solution. The alkali is exemplified by: inorganic alkalis such as sodium hydroxide, potassium hydroxide, sodium carbonate, sodium silicate, sodium metasilicate and ammonia; quaternary ammonium salts such as tetramethylammonium hydroxide and tetraethylammonium hydroxide; and the like. Such an aqueous alkaline solution may also be used with a water soluble organic solvent such as methanol and ethanol, a surfactant, and the like being added in appropriate amounts. Concentration of the alkali in the aqueous alkaline solution is preferably no less than 0.1% by mass, and no greater than 5% by mass in light of obtaining appropriate developability.

The organic solvent is exemplified by an alcohol solvent, an ether solvent, a ketone solvent, an amide solvent, an ester solvent, a hydrocarbon solvent, and the like.

Examples of the alcohol solvent include:
monohydric alcohol solvents such as methanol, ethanol, n-propanol, iso-propanol, n-butanol, iso-butanol, sec-butanol, tert-butanol, n-pentanol, iso-pentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, furfuryl alcohol, phenol, cyclohexanol, methylcyclohexanol, 3,3,5-trimethylcyclohexanol, benzyl alcohol and diacetone alcohol;
polyhydric alcohol solvents such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol and tripropylene glycol;
polyhydric alcohol partially etherated solvents such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether and dipropylene glycol monopropyl ether; and the like.

Examples of the ether solvent include:
dialiphatic ethers such as diethyl ether, dipropyl ether and dibutyl ether;
diaromatic ethers such as diphenyl ether and ditolyl ether;
aromatic-aliphatic ethers such as anisole and phenyl ethyl ether; and the like.

Examples of the ketone solvent include:
aliphatic ketone solvents such as acetone, methyl ethyl ketone, methyl n-propyl ketone, methyl n-butyl ketone, diethyl ketone, methyl iso-butyl ketone, 2-heptanone, ethyl n-butyl ketone, methyl n-hexyl ketone, di-iso-butyl ketone, trimethylnonanone, cyclopentanone, cyclohexanone, cycloheptanone, cyclooctanone, methylcyclohexanone, 2,4-pentane dione, acetonyl acetone and acetophenone;
aliphatic-aromatic ketone solvents such as acetophenone, propiophenone and trimethyl ketone;
aromatic ketone solvents such as benzophenone, tolyl phenyl ketone and ditolyl ketone; and the like.

Examples of the amide solvent include
N,N' -dimethylimidazolidinone, N-methylformamide, N,N-dimethylformamide, N,N-diethylformamide, acetamide, N-methylacetamide, N,N-dimethylacetamide, N-methylpropionamide, N-methylpyrrolidone, and the like.

Examples of the ester solvent include:
monoester solvents such as methyl acetate, ethyl acetate, n-propyl acetate, iso-propyl acetate, n-butyl acetate, iso-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, methoxytriglycol acetate, ethyl propionate, n-butyl propionate, iso-amyl propionate, methyl lactate, ethyl lactate, n-butyl lactate and n-amyl lactate;
diester solvents such as glycol diacetate, diethyl oxalate, di-n-butyl oxalate, diethyl malonate, dimethyl phthalate and diethyl phthalate;
polyhydric alcohol monoether acetate solvents such as ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate and dipropylene glycol monoethyl ether acetate;
lactone solvents such as γ-butyrolactone and γ-valerolactone;
carbonate solvents such as diethyl carbonate, dipropyl carbonate, ethylene carbonate and propylene carbonate; and the like.

Examples of the hydrocarbon solvent include:
aliphatic hydrocarbon solvents such as n-pentane, iso-pentane, n-hexane, iso-hexane, n-heptane, iso-heptane, 2,2,4-trimethylpentane, n-octane, iso-octane, cyclohexane and methylcyclohexane;
aromatic hydrocarbon solvents such as benzene, toluene, xylene, mesitylene, ethylbenzene, trimethylbenzene, methylethylbenzene, n-propylbenzene, iso-propylbenzene, diethylbenzene, iso-butylbenzene, triethylbenzene, di-iso-propylbenzene and n-amylnaphthalene; and the like.

Of these, the ether solvent, the ketone solvent and the ester solvent are preferred. As the ether solvent, the aromatic-aliphatic ether solvent is preferred, and anisole is particularly preferred. As the ketone solvent, the aliphatic ketone solvent is preferred, and 2-heptanone and cyclohexanone are particularly preferred. As the ester solvent, the monoester solvent and the polyhydric alcohol monoether acetate solvent are preferred, and butyl acetate and propylene glycol monomethyl ether acetate are particularly preferred. These organic solvents may be used in combination of two or more types thereof.

The lower limit of a content of the organic solvent in the organic solvent developer solution is preferably 80% by mass, more preferably 90% by mass, still more preferably 95% by mass, and particularly preferably 99% by mass. When the content of the organic solvent in the developer solution falls within the above range, a contrast between the light-exposed region and the light-unexposed region is enabled to be improved.

An appropriate amount of a surfactant may be added to the developer solution as needed. As the surfactant, for example, an ionic or nonionic fluorochemical, silicone surfactant and/or the like may be used.

The development procedure is exemplified by: a dipping procedure in which the substrate is immersed for a given time period in the developer solution charged in a container; a puddle procedure in which the developer solution is placed to form a dome-shaped bead by way of the surface tension on the surface of the substrate for a given time period to conduct a development; a spraying procedure in which the developer solution is sprayed onto the surface of the substrate; a dynamic dispensing procedure in which the developer solution is continuously applied onto the substrate that is rotated at a constant speed while scanning with a developer solution-application nozzle at a constant speed; and the like. A development time period varies depending on the formulation of the photoresist composition used, and is preferably no less than 10 sec and no more than 180 sec. Such a development process is followed by, for example, washing with running water for no less than 30 sec and no more than 90 sec, and then drying with compressed air or compressed nitrogen, thereby enabling a desired pattern to be formed.

The resist pattern-forming method preferably comprises, after the development step, a rinsing step of washing the resist film with a rinse agent. As the rinse agent in the rinsing step, water can be used. Using water, alcohol, etc. as the rinse agent enables scum generated to be efficiently washed.

### EXAMPLES

Hereinafter, the present invention is explained in detail by way of Examples, but the present invention is not limited to these Examples. Measuring methods for physical properties in connection with the Examples are shown below.

### Weight Average Molecular Weight (Mw) and Number Average Molecular Weight (Mn)

Mw and Mn of a polymer were measured by gel permeation chromatography (GPC) with mono-dispersed polystyrene as a standard, using GPC columns (G2000 HXL x 2, G3000 HXL x 1 and G4000 HXL x 1 (each available from Tosoh Corporation) under analysis conditions of: flow rate: 1.0 mL/min; elution solvent: tetrahydrofuran; sample concentration: 1.0% by mass; amount of injected sample: 100 µL; and column temperature: 40 °C, using a differential refractometer as a detector.

### ¹³C-NMR Analysis

A ¹³C-NMR analysis for determination of the proportion of the structural unit in the polymer was conducted by using a nuclear magnetic resonance apparatus ("JNM-ECX400" from JEOL, Ltd.), and CDCl₃ as a solvent for measurement, with tetramethylsilane (TMS) as an internal standard.

### Synthesis of (A) Polymer

Monomers used in the synthesis of the polymer (A) are shown below.

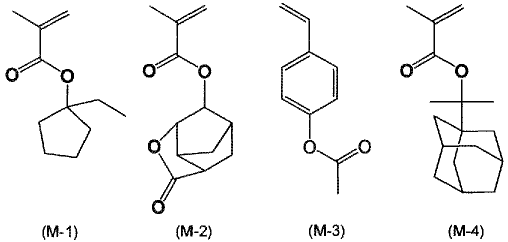

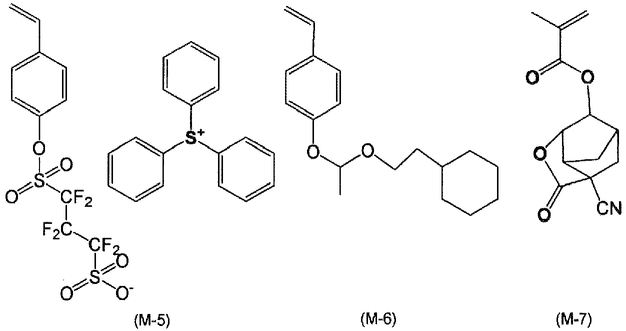

### Synthesis Example 1

After 55 g (50 mol%) of the compound (M-1), 45 g (50 mol%) of the compound (M-2) and 3 g of AIBN were dissolved in 300 g of methyl ethyl ketone, polymerization was permitted for 6 hrs in a nitrogen atmosphere while maintaining a reaction temperature at 78 °C. Following the polymerization, the reaction solution was added to 2,000 g of methanol dropwise to permit solidification of a polymer. Thereafter, the polymer was washed twice with 300 g of methanol, and white powder thus obtained was filtered, followed by drying at 50 °C overnight under a reduced pressure to give a polymer (A-1). The polymer (A-1) had the Mw of 7,000 and the Mw/Mn of 2.10. In addition, the result of the ¹³C-NMR analysis indicated that the proportions of the structural unit derived from the compound (M-1) and the structural unit derived from the compound (M-2) were 52 mol% and 48 mol%, respectively.

### Synthesis Example 2

After 55 g (42 mol%) of the compound (M-3), 45 g (58 mol%) of the compound (M-1), 3 g of AIBN and 1 g of t-dodecylmercaptan were dissolved in 150 g of propylene glycol monomethyl ether, polymerization was permitted for 16 hrs under a nitrogen atmosphere while maintaining a reaction temperature at 70 °C. Following the polymerization, the reaction solution was added to 1,000 g of n-hexane dropwise to permit solidification and purification of a polymer. Subsequently, 150 g of propylene glycol monomethyl ether was added again to the polymer, then 150 g of methanol, 37 g of trimethylamine and 7 g of water were further added thereto, and a hydrolysis reaction was allowed to proceed for 8 hrs with refluxing at the boiling point to permit deacetylation of the structural unit derived from (M-3). After the reaction, the solvent and triethylamine were distilled off under reduced pressure, the resulting polymer was dissolved in 150 g of acetone, and then the solution thus obtained was added to 2,000 g of water dropwise to permit solidification of the polymer. The white powder thus formed was filtered off and then dried at 50 °C overnight under a reduced pressure to give a polymer (A-2). The polymer (A-2) had the Mw of 6,000 and the Mw/Mn of 1.90. In addition, the result of the ¹³C-NMR analysis indicated that the proportions of the structural unit derived from p-hydroxystyrene and the structural unit derived from the compound (M-1) were 50 mol% and 50 mol%, respectively.

### Synthesis Examples 3 and 4

Polymers (A-3) and (A-4) were synthesized by a similar operation to that of Synthesis Example 2 except that the type and the content of monomers used were as shown in Table 1. Table 1 shows Mw, Mw/Mn, and proportions of the structural units of each resulting polymer.

**Table 1**

| | (A) Polymer | Monomer type | Proportion of structural unit contained (mol%) | Mw | Mw/Mn |
|---|---|---|---|---|---|
| Synthesis Example 1 | A-1 | M-1 | 52 | 7,000 | 2.10 |
| | | M-2 | 48 | | |
| Synthesis Example 2 | A-2 | M-1 | 50 | 6,000 | 1.90 |
| | | M-3 | 50 | | |
| Synthesis Example 3 | A-3 | I M-3 | 50 | 8,500 | 1.50 |
| | | M-4 | 43 | | |
| | | I M-5 | | | |
| Synthesis Example 4 | A-4 | M-3 | 40 | 9,600 | 1.72 |
| | | M-5 | 12 | | |
| | | M-6 | 35 | | |
| | | M-7 | 13 | | |

### Synthesis Example 5

In 50 mL of chloroform were dissolved 10 g of glutaraldehyde (50% by mass aqueous solution), 24.8 g of 3-methoxyphenol and 37.5 g of trifluoroacetic acid, and the mixture was refluxed for 48 hrs. The resulting solution was added to methanol and a precipitate was vacuum-dried to give 11.3 g of a single molecule (M-8) (described later) protected by a methoxy group. Subsequently, 8.0 g of the compound, 8.2 g of potassium carbonate, and 0.064 g of tetrabutylammonium bromide were dissolved in 95 mL of N-methylpyrrolidone (NMP), and the resulting solution was stirred at 60 °C for 3 hrs. Furthermore, a solution containing 4.3 g of 2-bromoacetyloxy-2-methyladamantane and 5 mL of NMP was added thereto, and the mixture was further stirred at 60 °C for 48 hrs. The reaction solution was poured into chloroform, and the mixture was washed with a 0.1 M aqueous oxalic acid solution. Following the washing, the mixture was dried over magnesium sulfate and filtered through Celite. The filtrate was concentrated under reduced pressure. The concentrated solution was added to methanol to allow a solid to be precipitated. The solid was then dried under reduced pressure to give 5.9 g of a compound (A-5) in which 18% of the hydroxyl group in (M-8) was protected with a 2-acetyloxy-2-methyladamantane group.

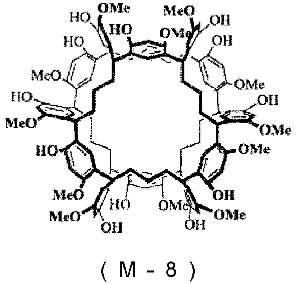

### Synthesis of (C) Particles

Compounds used for preparation of metal element-containing particles as the particles (C) are shown below.
MC-1: titanium(IV) tri-n-butoxide stearate (90% by mass solution in butanol)
MC-2: zirconium(IV) n-butoxide (80% by mass solution in butanol)
MC-3: zirconium(IV) n-propoxide (70% by mass solution in n-propanol)
MC-4: hafnium(IV) isopropoxide
MC-5: butyltin(IV) trichloride
MC-6: tantalum(V) pentaethoxide

### Particle Diameter Analysis

The hydrodynamic radius of the particles (C) containing the metal element was determined by DLS measurement using a light scattering measurement apparatus ("ALV-5000", available from ALV-GmbH, Germany).

### Synthesis Example 6

In 40.0 g of propylene glycol monoethyl ether (PGEE), 10.0 g of the compound (MC-1) was dissolved. To the resulting solution, a mixture of 10.0 g of PGEE and 0.46 g of maleic acid was added, and a mixed solution thus obtained was stirred for 1 hour at room temperature. Finally, PGEE was added to the mixed solution to give a particle-containing solution (C-1) having a solid content concentration of 10.0% by mass. The hydrodynamic radius of titanium-containing particles comprised in the particle-containing solution as determined by the DLS technique was less than 1 nm (below the analytical limit).

### Synthesis Example 7

In 10.0 g of tetrahydrofuran (THF), 4.0 g of the compound (MC-2) was dissolved, and then 8.0 g of methacrylic acid was added thereto. The mixture thus obtained was stirred at room temperature for 24 hrs. The resulting solution was mixed with 100 g of hexane to generate a precipitate. The precipitate was collected, washed with hexane, and dried in vacuo to give 2.5 g of zirconium-containing particles. The zirconium-containing particles were dispersed in ethyl lactate (EL) and the dispersion was stirred for 1 hour to give a particle-containing solution (C-2) having a solid content concentration of 10.0% by mass. The hydrodynamic radius of the zirconium-containing particles comprised in the particle-containing solution as determined by the DLS technique was 18 nm.

### Synthesis Example 8

In 10.0 g of tetrahydrofuran (THF)4.0 g of the compound (MC-2) was dissolved, and then 8.0 g of methacrylic acid was added thereto. The mixture thus obtained was stirred at 60 °C for 24 hrs. The resulting solution was mixed with 100 g of hexane to generate a precipitate. The precipitate was collected, washed with hexane, and dried in vacuo to give 2.8 g of zirconium-containing particles. The zirconium-containing particles were dispersed in ethyl lactate (EL) and the dispersion was stirred for 1 hour to give a particle-containing solution (C-2') having a solid content concentration of 10.0% by mass. The hydrodynamic radius of the zirconium-containing particles comprised in the particle-containing solution as determined by the DLS technique was 30 nm.

### Synthesis Example 9

To 4.0 g of the compound (MC-3) were added 4.0 g of methacrylic acid and 2.0 g of acetic acid. A precipitate was confirmed to have been generated after the mixture was stirred at room temperature for 72 hrs. The precipitate was washed with hexane and then dried in vacuo to give 2.0 g of zirconium-containing particles. The zirconium-containing particles were dispersed in propylene glycol monomethyl ether acetate (PGMEA) and the dispersion was stirred for 1 hour to give a particle-containing solution (C-3) having a solid content concentration of 10.0% by mass. The hydrodynamic radius of the zirconium-containing particles comprised in the particle-containing solution as determined by the DLS technique was 2 nm.

### Synthesis Example 10

To 4.2 g of the compound (MC-4), 8.0 g of trans-2,3-dimethylacrylic acid was added. The mixture was stirred at 65 °C for 30 min and then 0.3 g of water was added thereto. After further heating at 65 °C for 18 hrs and addition of 10 g of water, a precipitate was confirmed to have been generated. The precipitate was collected by centrifugal separation and dissolved in 5 g of acetone. 10 g of water was added thereto to allow precipitation to occur again. The precipitate was subjected to another centrifugal separation and then to vacuum drying, to give 1.3 g of hafnium-containing particles. The hafnium-containing particles were dispersed in propylene glycol monomethyl ether acetate (PGMEA) and the dispersion was stirred for 1 hour to give a particle-containing solution (C-4) having a solid content concentration of 10.0% by mass. The hydrodynamic radius of the hafnium-containing particles comprised in the particle-containing solution as determined by the DLS technique was 1.2 nm.

### Synthesis Example 11

In a flask, 20 mL of water and 6.3 g of 25% by mass aqueous ammonium hydroxide solution were mixed. A nitrogen atmosphere was provided in the flask, and then the aqueous solution was cooled in an ice bath. Thereto, 4.2 g of the compound (MC-5) was added at once and the resulting aqueous solution was then refluxed for 30 min. After cooling, the aqueous solution was filtered through Celite and the filtrate was extracted with ethyl acetate three times. To the organic phase, sodium sulfate was added. The mixture was filtered through Celite, and the filtrate was concentrated under reduced pressure and diluted with diethyl ether. To the dilution, hexane was added to allow for precipitation of a solid. The solid was dried under reduced pressure to give 1.5 g of tin-containing particles. The tin-containing particles were dispersed in methyl ethyl ketone (MEK) to give a particle-containing solution (C-5) having a solid content concentration of 10.0% by mass. The hydrodynamic radius of the tin-containing particles comprised in the particle-containing solution as determined by the DLS technique was 5 nm.

### Synthesis Example 12

In 100 mL of dehydrated tetrahydrofuran, 4.1 g of the compound (MC-6) was dissolved, and 1.55 g of ethylene glycol was added thereto at room temperature. After stirring of the resulting solution for 24 hrs, 60 g of propylene glycol monomethyl ether acetate (PGMEA) was added thereto. The mixture was concentrated under reduced pressure to eliminate tetrahydrofuran, ethanol generated as a by-product, and a part of PGMEA having been added, thereby giving a particle-containing solution (C-6) having a solid content concentration of 10.0% by mass. The hydrodynamic radius of the tantalum-containing particles comprised in the particle-containing solution as determined by the DLS technique was 3 nm.

The particle-containing solutions (C-1) to (C-6) and (C-2') obtained in Synthesis Examples 6 to 12 are shown in Table 2 below.

**Table 2**

| | (C) Particle-containing solution | Metal compound | | Organic compound | | (G) Solvent | Reaction temperature | Hydrodynamic radius |
|---|---|---|---|---|---|---|---|---|
| | | Type | Amount (g) | Type | Amount (g) | | | |
| Synthesis Example 6 | C-1 | MC-1 | 10.0 | Maleic acid | 0.46 | PGEE | Room temperature | < 1 nm |
| Synthesis Example 7 | C-2 | MC-2 | 4.0 | Methacrylic acid | 8.0 | EL | Room temperature | 18 nm |
| Synthesis Example 8 | C-2' | MC-2 | 4.0 | Methacrylic acid | 8.0 | EL | 60 °C | 30 nm |
| Synthesis Example 9 | C-3 | MC-3 | 4.0 | Methacrylic acid/ Acetic acid | 4.0/2.0 | PGMEA | Room temperature | 2 nm |
| Synthesis Example 10 | C-4 | MC-4 | 4.2 | trans-2,3-dimethylacrylic acid | 8.0 | PGMEA | 65 °C | 1.2 nm |
| Synthesis Example 11 | C-5 | MC-5 | 4.2 | - | - | MEK | 100 °C | 5 nm |
| Synthesis Example 12 | C-6 | MC-6 | 4.1 | Ethylene glycol | 1.55 | PGMEA | Room temperature | 3 nm |

### Preparation of Photoresist Composition

Components other than the polymer (A) and the particles (C) used for preparation of the photoresist compositions are shown below.

### (B) Acid Generating Agent

B-1: triphenylsulfonium nonafluoro-n-butanesulfonate (compound represented by the following formula (B-1))
B-2: triphenylsulfonium 2-(4-oxo-adamantan-1-ylcarbonyloxy)-1,1,3,3,3-pentafluoropropane-1-sulfonate (compound represented by the following formula (B-2))

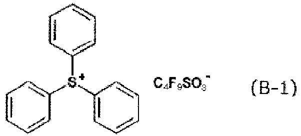

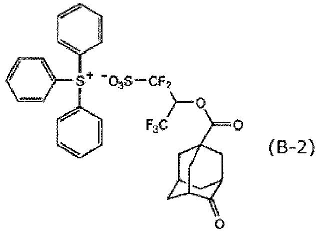

### Acid Diffusion Control Agent

E-1: triphenylsulfonium salicylate (compound represented by the following formula (E-1))
E-2: 2,4,5-triphenylimidazole (compound represented by the following formula (E-2))

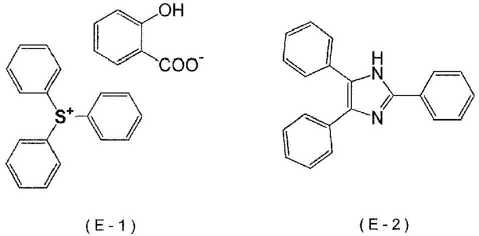

### (G) Solvent

G-1: propylene glycol monomethyl ether acetate
G-2: ethyl lactate
G-3: cyclohexanone

### Example 1 - Reference Example useful to understand the invention

A photoresist composition (R-2) was prepared by mixing 100 parts by mass of the polymer (A-1), 27 parts by mass of (B-1) as the acid generating agent (B), 50 parts by mass (5 parts by mass on solid basis) of the solution (C-1) containing the particles (C), 2.6 parts by mass of (E-1) as the acid diffusion control agent, and 4,300 parts by mass of (G-1) and 1,900 parts by mass of (G-2) as the solvent (G), and then filtering the mixture solution thus obtained through a membrane filter having a pore size of 0.20 µm.

### Examples 2 to 8 and Comparative Examples 1 to 6

Each photoresist composition was prepared by a similar operation to that in Example 1 except that the type and the amount of each component blended were as shown in Table 3.

**Table 3**

| | Photoresist composition | (A) Polymer | | (B) Acid generating agent | | (C) Particle-contammg solution | | Acid diffusion controller | | (G) Solvent | |
|---|---|---|---|---|---|---|---|---|---|---|---|
| | | Type | Amount blended (parts by mass) | Type | Amount blended (parts by mass) | Type | Amount blended (parts by mass) | Type | Amount blended (parts by mass) | Type | Amount blended (parts by mass) |
| Comparative Example 1 | R-1 | A-1 | 100 | B-1 | 27 | - | - | E-1 | 2.6 | G-1/G-2 | 4,300/1,900 |
| Example 1 | R-2 | A-1 | 100 | B-1 | 27 | C-1 | 50 | E-1 | 2.6 | G-1/G-2 | 4,300/1,900 |
| Comparative Example 2 | R-3 | A-2 | 100 | B-1 | 27 | - | - | E-1 | 2.6 | G-1/G-2 | 4,300/1,900 |
| Example 2 | R-4 | A-2 | 100 | B-1 | 27 | C-2 | 100 | E-1 | 2.6 | G-1/G-2 | 4,300/1,900 |
| Comparative Example 3 | R-5 | A-2 | 100 | B-1 | 27 | C-2' | 100 | E-1 | 2.6 | G-1/G-2 | 4,300/1,900 |
| Example 3 | R-6 | A-2 | 100 | B-1 | 27 | C-3 | 30 | E-1 | 2.6 | G-1 | 5,800 |
| Example 4 | R-7 | A-2 | 100 | B-1 | 27 | C-3 | 300 | E-1 | 2.6 | G-1 | 5,800 |
| Comparative Example 4 | R-8 | A-3 | 100 | B-2 | 23 | - | - | E-1 | 2.2 | G-1 | 5,800 |
| Example 5 | R-9 | A-3 | 100 | B-2 | 23 | C-4 | 150 | E-1 | 2.2 | G-1 | 5,800 |
| Comparative Example 5 | R-10 | A-4 | 100 | B-2 | 23 | - | - | E-2 | 2.0 | G-1/G-3 | 5,000/1,000 |
| Example 6 | R-11 | A-4 | 100 | B-2 | 23 | C-5 | 50 | E-2 | 2.0 | G-1/G-3 | 5,000/1,000 |
| Comparative Example 6 | R-12 | A-5 | 100 | B-1 | 30 | - | - | E-1 | 2.5 | G-1 | 5,800 |
| Example 7 | R-13 | A-5 | 100 | B-1 | 30 | C-4 | 50 | E-1 | 2.5 | G-1 | 5,800 |
| Example 8 | R-14 | A-2 | 100 | B-1 | 27 | C-6 | 100 | E-1 | 2.6 | G-1/G-2 | 5,000/1,000 |

### Formation of Resist Pattern

### Example 9 - Reference Example useful to understand the invention

The photoresist composition (R-2) prepared in Example 1 was spin-coated onto a silicon wafer in "CLEAN TRACK ACT-8" available from Tokyo Electron Limited, and subjected to PB at 110 °C for 60 sec to provide a resist film having a thickness of 50 nm. Subsequently, the resist film was irradiated with an electron beam using a simplified electron beam writer ("HL800D" available from Hitachi, Ltd., power: 50 KeV, current density: 5.0 ampere/cm²) to permit patterning. After the irradiation with the electron beam, PEB was carried out at 100 °C for 60 sec in the CLEAN TRACK ACT-8. Thereafter, development was carried out according to the puddle procedure at 23 °C for 1 min using a 2.38% by mass aqueous tetramethylammonium hydroxide (TMAH) solution in the CLEAN TRACK ACT-8. Thereafter, the substrate was washed with pure water and then dried, whereby a positive tone resist pattern was formed.

### Examples 10 to 16 and Comparative Examples 7 to 12

Each resist pattern was formed by a similar operation to that in Example 9 except that the photoresist composition shown in Table 4 was used. The positive tone resist patterns thus formed were each evaluated for the sensitivity and the nanoedge roughness property as described later. The results of the evaluations are shown in Table 4.

### Example 17 - Reference Example useful to understand the invention - and Comparative Example 13

A similar operation to that in Example 9 was carried out up to the PEB, except that the photoresist composition shown in Table 4 was used. Then, in the CLEAN TRACK ACT-8, development was carried out according to a puddle procedure at 23 °C for 1 min using butyl acetate (AcOBu). Thereafter, the substrate was dried, whereby a negative tone resist pattern was formed. The resist patterns thus formed were each evaluated for the sensitivity and the nanoedge roughness property as described later. The results of the evaluations are shown in Table 4.

### Sensitivity (µC/cm²)

An exposure dose at which a line and space pattern (1L 1S) configured with a line part having a line width of 150 nm and a space part formed by neighboring line parts with an interval of 150 nm was formed to give a line width of 1:1 was defined as "optimal exposure dose", and the "optimal exposure dose" was defined as "sensitivity" (µC/cm²). The sensitivity was determined to be: "AA (extremely favorable)" in the case of being less than 35 (µC/cm²); "A (favorable)" in the case of being no less than 35 (µC/cm²) and no greater than 40 (µC/cm²); and "B (unfavorable)" in the case of being greater than 40 (µC/cm²).

### Nanoedge Roughness Property (nm)

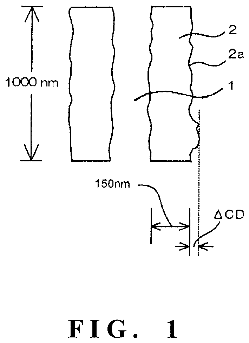

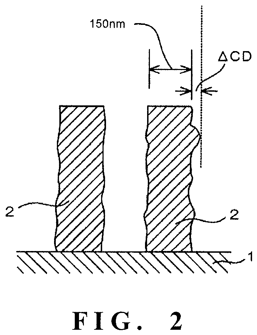

The line patterns of the line and space pattern (1L 1S) were observed using a high-resolution FEB critical dimension measurement device (S-9220, available from Hitachi, Ltd.). Arbitrary twenty points on the substrate were observed, and with respect to the observed shape, a difference "ΔCD" between an intended line width of 150 nm and a line width in an area in which irregularities generated along the side lateral surface 2a of the line part (resist pattern) 2 of the resist film formed on the silicon wafer (substrate) 1 were most significant was measured as shown in FIGS. 1 and 2. The average value of the ΔCD values was defined as "nanoedge roughness" (nm). The nanoedge roughness property was determined to be: "AA (extremely favorable)" in the case of being no greater than 15.0 nm; "A (favorable)" in the case of being greater than 15.0 nm and no greater than 16.5 nm; and "B (unfavorable)" in the case of being greater than 16.5 nm. It is to be noted that the irregularities shown in FIGS. 1 and 2 are exaggerated.

### Storage Stability

The photoresist compositions obtained in the Examples and Comparative Examples were stored at 40 °C for 3 months and then subjected to a resist pattern forming test. A change in exposure dose for forming a 1:1 line and space pattern (1L 1S) having a line width of 150 nm, found after the storage as compared with before the storage, was determined to be: "AA (extremely favorable)" in the case of being less than 5%; "A (favorable)" in the case of being no less than 5% and no greater than 10%; and "B (unfavorable)" in the case of being greater than 10%.

**Table 4**

| | Photoresist composition | Developer solution | Evaluation results | | | | |
|---|---|---|---|---|---|---|---|
| | | | Sensitivity | | Nanoedge roughness property | | Storage stability |
| | | | (µC/cm²) | Evaluation | (nm) | Evaluation | |
| Example 9 | R-2 | TMAH | 32.0 | AA | 15.5 | A | A |
| Example 10 | R-4 | TMAH | 28.0 | AA | 14.9 | AA | A |
| Example 11 | R-6 | TMAH | 33.0 | AA | 14.8 | AA | AA |
| Example 12 | R-7 | TMAH | 25.0 | AA | 16.4 | A | AA |
| Example 13 | R-9 | TMAH | 34.0 | AA | 15.2 | A | AA |
| Example 14 | R-11 | TMAH | 31.0 | AA | 14.2 | AA | AA |
| Example 15 | R-13 | TMAH | 33.0 | AA | 13.5 | AA | AA |
| Example 16 | R-14 | TMAH | 32.0 | AA | 14.4 | AA | AA |
| Example 17 | R-2 | AcOBu | 29.0 | AA | 15.8 | A | A |
| Comparative Example 7 | R-1 | TMAH | 45.0 | B | 15.6 | A | AA |
| Comparative Example 8 | R-3 | TMAH | 43.0 | B | 15.3 | A | AA |
| Comparative Example 9 | R-5 | TMAH | 27.0 | AA | 17.8 | B | B |
| Comparative Example 10 | R-8 | TMAH | 57.0 | B | 15.4 | A | AA |
| Comparative Example 11 | R-10 | TMAH | 50.0 | B | 14.1 | AA | AA |
| Comparative Example 12 | R-12 | TMAH | 45.0 | B | 13.3 | AA | AA |
| Comparative Example 13 | R-1 | AcOBu | 41.0 | B | 15.9 | A | A |

### Examples 9 and 17 are Reference Examples useful to understand the invention

From the results shown in Table 4, it was verified that adding the metal element-containing particles having a hydrodynamic radius of no greater than 20 nm to the compound (A) enabled the sensitivity to be improved while maintaining the nanoedge roughness performance. On the other hand, it was ascertained that the hydrodynamic radius of the particles greater than 20 nm led to deterioration of the nanoedge roughness property. Furthermore, it was ascertained that in a case where the photoresist composition contained no protic solvent, even the composition containing the metal element-containing particles had further favorable storage stability.

### [INDUSTRIAL APPLICABILITY]

Especially in a lithography technique in which EUV or an electron beam is used, the present invention enables a photoresist composition in which sensitivity is improved while a nanoedge roughness performance is maintained, and a resist pattern-forming method in which the photoresist composition is used, to be provided by blending a small amount of the metal element-containing particles into a conventionally used resist that provides a film having a solubility in a developer solution that is to be altered by an action of an acid. Therefore, the photoresist composition and the resist pattern-forming method may be suitably used for forming resist patterns in lithography steps for various types of electronic devices such as semiconductor devices and liquid crystal devices.

### [EXPLANATION OF THE REFERENCE SYMBOLS]

1 Substrate
2 Resist pattern
2a Lateral side face of resist pattern

## Claims

1. A photoresist composition comprising:
a radiation-sensitive acid generator that is capable of generating an acid upon irradiation with a radioactive ray, an action of the acid allowing a solubility in a developer solution to be altered;
first particles comprising a metal element and having a hydrodynamic radius as determined by a dynamic light scattering analysis being no greater than 20 nm;
a first compound comprising an acid-labile group; and
a first solvent,
wherein the first particles are a complex or a hydrolytic condensation product thereof, the complex being obtained by mixing a metal-containing compound which is a first metal compound comprising a hydrolyzable group, a hydrolysis product of the first metal compound, a hydrolytic condensation product of the first metal compound, or a combination thereof, with at least one type of organic compound represented by formula (L-1):
R¹-(-X)ₙ (L-1)
wherein in the formula (L-1),
R¹ represents an organic group having a valency of n;
X represents -OH, -COOH, -NCO, -NHR^{a}, -COOR^{A}, or -CO-C(R^{L})₂-COR^{A},
R^{a} representing a hydrogen atom or a monovalent organic group,
R^{A} representing a monovalent organic group, and
R^{L} each independently representing a hydrogen atom or a monovalent organic group; and
n is an integer of 1 to 4,
in a case where n is no less than 2, a plurality of Xs are identical or different,
wherein the metal element is zirconium, hafnium, tantalum, tungsten, iron, zinc, tin, or bismuth, and
wherein the first compound is a first polymer comprising a first structural unit comprising an acid-labile group.

2. The photoresist composition according to claim 1, wherein the radiation-sensitive acid generator is the first compound comprising a group that is capable of generating the acid upon irradiation with a radioactive ray.

3. The photoresist composition according to claim 1 or 2, comprising a radiation-sensitive acid generating agent as the radiation-sensitive acid generator.

4. The photoresist composition according to any one of claims 1 to 3, wherein a content of the first particles is no greater than 20 parts by mass with respect to 100 parts by mass of the first compound.

5. The photoresist composition according to any one of claims 1 to 4, wherein the first polymer further comprises a second structural unit comprising an aromatic ring having 6 to 20 carbon atoms in the ring thereof.

6. The photoresist composition according to claim 5, wherein at least one hydroxy group bonds to the aromatic ring.

7. The photoresist composition according to any one of claims 1 to 6, wherein the metal-containing compound to be mixed with the organic compound is a metal alkoxide having been neither hydrolyzed nor hydrolytically condensed.

8. The photoresist composition according to any one of claims 1 to 7, wherein in the formula (L-1), X represents -OH, and n is 2 to 4.

9. The photoresist composition according to any one of claims 1 to 7, wherein in the formula (L-1), X represents -COOH, and n is 1.

10. The photoresist composition according to any one of claims 1 to 9, wherein the first solvent comprises an aprotic solvent in an amount of no less than 80% by mass.

11. The photoresist composition according to any one of claims 1 to 10, wherein the first solvent comprises a protic solvent in an amount of no greater than 20% by mass.

12. A production method of the photoresist composition according to any one of claims 1 to 11, comprising
mixing a liquid obtained by dispersing the first particles in a second solvent, with other components.

13. The production method according to claim 12, comprising dispersing in the second solvent the first particles in a state of a solid.

14. The production method according to claim 12 or 13, wherein the second solvent is an aprotic solvent.

15. A resist pattern-forming method comprising:
providing a resist film;
exposing the resist film by irradiating with an extreme ultraviolet ray or an electron beam; and
developing with a developer solution the resist film exposed,
wherein the resist film is provided from the photoresist composition according to any one of claims 1 to 11.

16. The resist pattern-forming method according to claim 15, wherein the developer solution is an aqueous alkaline solution.

17. The resist pattern-forming method according to claim 15, wherein the developer solution is an organic solvent.

## Patentansprüche

1. Photoresistzusammensetzung, die umfasst:
einen strahlungsempfindlichen Säuregenerator, der in der Lage ist, bei Bestrahlung mit einem radioaktiven Strahl eine Säure zu erzeugen, wobei durch die Wirkung der Säure eine Löslichkeit in einer Entwicklerlösung verändert werden kann;
erste Teilchen, die ein Metallelement umfassen und einen hydrodynamischen Radius aufweisen, der durch eine dynamische Lichtstreuungsanalyse bestimmt wird und der nicht größer als 20 nm ist;
eine erste Verbindung, die eine säurelabile Gruppe umfasst; und
ein erstes Lösungsmittel,
wobei die ersten Teilchen ein Komplex oder ein hydrolytisches Kondensationsprodukt davon sind, wobei der Komplex durch Mischen einer metallhaltigen Verbindung, die eine erste Metallverbindung mit einer hydrolysierbaren Gruppe, ein Hydrolyseprodukt der ersten Metallverbindung, ein hydrolytisches Kondensationsprodukt der ersten Metallverbindung oder eine Kombination davon ist, mit zumindest einer Art einer durch die Formel (L-1) dargestellten organischen Verbindung erhalten wird:
R¹-(-X)ₙ (L-1)
wobei in der Formel (L-1),
R¹ eine organische Gruppe mit einer Wertigkeit von n darstellt;
X -OH, -COOH, -NCO, -NHR^{a}, -COOR^{A} oder -CO-C(R^{L})₂-CO-R^{A} darstellt,
R^{a} ein Wasserstoffatom oder eine einwertige organische Gruppe darstellt,
R^{A} eine einwertige organische Gruppe darstellt, und
R^{L} jeweils unabhängig ein Wasserstoffatom oder eine einwertige organische Gruppe darstellt; und
n eine ganze Zahl von 1 bis 4 ist,
wobei in einem Fall, in dem n nicht kleiner als 2 ist, eine Mehrzahl von X gleich oder unterschiedlich ist,
wobei das Metallelement Zirkonium, Hafnium, Tantal, Wolfram, Eisen, Zink, Zinn oder Bismut ist, und
wobei die erste Verbindung ein erstes Polymer ist, das eine erste Struktureinheit mit einer säurelabilen Gruppe umfasst.

2. Photoresistzusammensetzung nach Anspruch 1, wobei der strahlungsempfindliche Säuregenerator die erste Verbindung ist, die eine Gruppe umfasst, die in der Lage ist, bei Bestrahlung mit einem radioaktiven Strahl die Säure zu erzeugen.

3. Photoresistzusammensetzung nach Anspruch 1 oder 2, die ein strahlungsempfindliches Säure-erzeugendes Mittel als den strahlungsempfindlichen Säuregenerator enthält.

4. Photoresistzusammensetzung nach einem der Ansprüche 1 bis 3, wobei ein Gehalt der ersten Teilchen nicht mehr als 20 Masseteile, bezogen auf 100 Masseteile der ersten Verbindung, beträgt.

5. Photoresistzusammensetzung nach einem der Ansprüche 1 bis 4, wobei das erste Polymer ferner eine zweite Struktureinheit umfasst, die einen aromatischen Ring mit 6 bis 20 Kohlenstoffatomen in seinem Ring umfasst.

6. Photoresistzusammensetzung nach Anspruch 5, wobei zumindest eine Hydroxygruppe an den aromatischen Ring bindet.

7. Photoresistzusammensetzung nach einem der Ansprüche 1 bis 6, wobei die metallhaltige Verbindung, die mit der organischen Verbindung gemischt werden soll, ein Metallalkoxid ist, das weder hydrolysiert noch hydrolytisch kondensiert worden ist.

8. Photoresistzusammensetzung nach einem der Ansprüche 1 bis 7, wobei in der Formel (L-1) X -OH darstellt und n 2 bis 4 ist.

9. Photoresistzusammensetzung nach einem der Ansprüche 1 bis 7, wobei in der Formel (L-1) X für -COOH steht und n 1 ist.

10. Photoresistzusammensetzung nach einem der Ansprüche 1 bis 9, wobei das erste Lösungsmittel ein aprotisches Lösungsmittel in einer Menge von nicht weniger als 80 Massen-% umfasst.

11. Photoresistzusammensetzung nach einem der Ansprüche 1 bis 10, wobei das erste Lösungsmittel ein protisches Lösungsmittel in einer Menge von nicht mehr als 20 Massen-% enthält.

12. Verfahren zur Herstellung einer Photoresistzusammensetzung nach einem der Ansprüche 1 bis 11, das umfasst
Mischen einer Flüssigkeit, die durch Dispergieren der ersten Teilchen in einem zweiten Lösungsmittel erhalten wurde, mit anderen Komponenten.

13. Herstellungsverfahren nach Anspruch 12, das das Dispergieren der ersten Teilchen im Zustand eines Feststoffs im zweiten Lösungsmittel umfasst.

14. Herstellungsverfahren nach Anspruch 12 oder 13, wobei das zweite Lösungsmittel ein aprotisches Lösungsmittel ist.

15. Resistmuster-Bildungsverfahren, das umfasst:
Bereitstellen eines Resistfilms;
Belichten des Resistfilms durch Bestrahlung mit einem extremen Ultraviolettstrahl oder einem Elektronenstrahl; und
Entwickeln des belichteten Resistfilms mit einer Entwicklerlösung,
wobei der Resistfilm aus der Photoresistzusammensetzung nach einem der Ansprüche 1 bis 11 bereitgestellt wird.

16. Resistmuster-Bildungsverfahren nach Anspruch 15, wobei die Entwicklerlösung eine wässrige alkalische Lösung ist.

17. Resistmuster-Bildungsverfahren nach Anspruch 15, wobei die Entwicklerlösung ein organisches Lösungsmittel ist.

## Revendications

1. Composition de réserve photographique comprenant :
un générateur d'acide sensible à un rayonnement qui est capable de générer un acide suite à une irradiation par un rayon radioactif, l'action de l'acide permettant une altération de la solubilité dans une solution de révélateur ;
des premières particules comprenant un élément métallique et ayant un rayon hydrodynamique, tel que déterminé par une analyse de diffusion dynamique de la lumière, non supérieur à 20 nm ;
un premier composé comprenant un groupe labile aux acides ; et
un premier solvant,
dans laquelle les premières particules sont un complexe ou un produit de condensation hydrolytique de celui-ci, le complexe étant obtenu par mélange d'un composé contenant un métal, qui est un premier composé métallique comprenant un groupe hydrolysable, un produit d'hydrolyse du premier composé métallique, un produit de condensation hydrolytique du premier composé métallique, ou une de leurs combinaisons, avec au moins un type de composé organique représenté par la formule (L-1) :
R¹-(-X)ₙ (L-1)
où, dans la formule (L-1),
R¹ représente un groupe organique ayant une valence de n ;
X représente -OH, -COOH, -NCO, -NHR^{a}, -COOR^{A}, ou -CO-C(R^{L})₂-CO-R^{A},
R^{a} représentant un atome d'hydrogène ou un groupe organique monovalent,
R^{A} représentant un groupe organique monovalent, et
chaque R^{L} représentant indépendamment un atome d'hydrogène ou un groupe organique monovalent ; et
n est un entier de 1 à 4,
dans le cas où n vaut au moins 2, les plusieurs X sont identiques ou différents,
dans laquelle l'élément métallique est le zirconium, le hafnium, le tantale, le tungstène, le fer, le zinc, l'étain ou le bismuth, et
dans laquelle le premier composé est un premier polymère comprenant un premier motif structurel comprenant un groupe labile aux acides.

2. Composition de réserve photographique selon la revendication 1, dans laquelle le générateur d'acide sensible à un rayonnement est le premier composé comprenant un groupe qui est capable de générer l'acide suite à une irradiation par un rayon radioactif.

3. Composition de réserve photographique selon la revendication 1 ou 2, comprenant un agent générateur d'acide sensible à un rayonnement en tant que générateur d'acide sensible à un rayonnement.

4. Composition de réserve photographique selon l'une quelconque des revendications 1 à 3, dans laquelle la teneur en les premières particules n'est pas supérieure à 20 parties en masse pour 100 parties en masse du premier composé.

5. Composition de réserve photographique selon l'une quelconque des revendications 1 à 4, dans laquelle le premier polymère comprend en outre un deuxième motif structurel comprenant un cycle aromatique ayant 6 à 20 atomes de carbone dans son cycle.

6. Composition de réserve photographique selon la revendication 5, dans laquelle au moins un groupe hydroxy se lie au cycle aromatique.

7. Composition de réserve photographique selon l'une quelconque des revendications 1 à 6, dans laquelle le composé contenant un métal devant être mélangé avec le composé organique est un alkylate métallique qui n'a été ni hydrolysé ni condensé par voie hydrolytique.

8. Composition de réserve photographique selon l'une quelconque des revendications 1 à 7, dans laquelle, dans la formule (L-1), X représente -OH, et n vaut de 2 à 4.

9. Composition de réserve photographique selon l'une quelconque des revendications 1 à 7, dans laquelle, dans la formule (L-1), X représente -COOH, et n vaut 1.

10. Composition de réserve photographique selon l'une quelconque des revendications 1 à 9, dans laquelle le premier solvant comprend un solvant aprotique en une quantité non inférieure à 80 % en masse.

11. Composition de réserve photographique selon l'une quelconque des revendications 1 à 10, dans laquelle le premier solvant comprend un solvant protique en une quantité non supérieure à 20 % en masse.

12. Procédé de production de la composition de réserve photographique de l'une quelconque des revendications 1 à 11, comprenant le mélange d'un liquide obtenu par dispersion des premières particules dans un deuxième solvant, avec d'autres composants.

13. Procédé de production selon la revendication 12, comprenant la dispersion dans le deuxième solvant des premières particules à l'état solide.

14. Procédé de production selon la revendication 12 ou 13, dans lequel le deuxième solvant est un solvant aprotique.

15. Procédé de formation de motif de réserve, comprenant :
l'obtention d'un film de réserve ;
l'exposition du film de réserve par irradiation avec un rayon ultraviolet extrême ou un faisceau d'électrons ; et
le développement avec une solution de révélateur du film de réserve exposé,
dans lequel le film de réserve est obtenu à partir de la composition de réserve photographique selon l'une quelconque des revendications 1 à 11.

16. Procédé de formation de motif de réserve selon la revendication 15, dans lequel la solution de révélateur est une solution aqueuse alcaline.

17. Procédé de formation de motif de réserve selon la revendication 15, dans lequel la solution de révélateur est un solvant organique.
